# EUROPEAN PATENT APPLICATION

(11) **EP 4 800 947 A1**
(43) Date of publication of application: **02.09.2026**
(21) Application number: 24899725.6
(22) Date of filing: 29.11.2024
(51) Int. Cl.: H04L 1/00

(54) **ENCODING METHOD, DECODING METHOD, AND APPARATUS**

(30) Priority: 04.12.2023 CN 202311652604
(71) Applicant: Huawei Technologies Co., Ltd., Shenzhen, Guangdong 518129 (CN)
(72) Inventor: LIN, Wei, Shenzhen, Guangdong 518129 (CN); MONTORSI, Guido, 10131 Torino (IT); BENEDETTO, Sergio, 10122 Torino (IT); YU, Jian, Shenzhen, Guangdong 518129 (CN); GAN, Ming, Shenzhen, Guangdong 518129 (CN)
(74) Representative: Goddar, Heinz J.
(86) International application number: PCT/CN2024/135519
(87) International publication number: WO 2025/119085

(57) **Abstract**

An encoding method, a decoding method, and an apparatus are provided, and are applied to support a next-generation Wi-Fi protocol (for example, 802.11be, Wi-Fi 7, or EHT) of IEEE 802.11ax, a next-generation Wi-Fi protocol (for example, 802.11bn, Wi-Fi 8, or UHR) of IEEE 802.11be, Wi-Fi AI, millimeter wave (MMW), ultra-wideband (UWB), sensing, or the like. The method includes: A first communication apparatus obtains an information bit sequence, performs LDPC encoding on the information bit sequence based on a parity check matrix, to obtain an encoded sequence, and outputs the sequence. A length of the sequence is N₁, where N₁ is n times 1944, and n is an integer greater than or equal to 2. After obtaining to-be-decoded information, a second communication apparatus performs LDPC decoding based on the parity check matrix, to obtain the information bit sequence. The method can improve decoding performance.

## Description

This application claims priority to Chinese Patent Application No. 202311652604.X, filed with the China National Intellectual Property Administration on December 4, 2023, and entitled "ENCODING METHOD, DECODING METHOD, AND APPARATUS", which is incorporated herein by reference in its entirety.

### TECHNICAL FIELD

This application relates to the field of communication technologies, and in particular, to an encoding method, a decoding method, and an apparatus.

### BACKGROUND

Wireless local area networks (wireless local area networks, WLAN) transmission standards such as the institute of electrical and electronics engineers (institute of electrical and electronics engineers) 802.11n/ac/ax/be mainly study improving user experience in a high-bandwidth (for example, 60 GHz (GHz)) scenario, including improving an average user throughput and energy efficiency of a battery-type power supply device. In the high-bandwidth scenario, high-speed and reliable transmission of services such as data and videos on limited frequency and power resources needs to be supported. Therefore, a highly reliable and efficient channel encoding/decoding scheme is required.

In the field of channel encoding, a concatenated code (such as a Turbo code) and a low-density parity-check (low-density parity-check, LDPC) code are two most mature and widely used channel encoding methods currently, and both have performance close to the shannon (shannon) limit. Compared with the concatenated code, the LDPC code may have the following advantages: Good bit error performance can be obtained without a deep interleaver; better frame error rate performance is provided; an error floor is greatly reduced; decoding is not based on a grid; and parallel decoding is supported and a decoding latency is small. Therefore, the LDPC code has become a standard channel encoding scheme for a low-frequency short-distance WLAN communication system such as IEEE 802.11n/ac/ax.

How to further improve decoding performance of the LDPC code needs to be urgently resolved.

### SUMMARY

Embodiments of this application provide an encoding method, a decoding method, and an apparatus, to support an LDPC code with a longer code length, and improve decoding performance.

According to a first aspect, an embodiment of this application provides an encoding method. The method is applied to a first communication apparatus, the first communication apparatus includes a Wi-Fi device, or a chip, a functional module, or the like that may be disposed in the Wi-Fi device, and the method includes:
obtaining an information bit sequence; performing low-density parity-check LDPC encoding on the information bit sequence based on a parity check matrix, to obtain an encoded sequence, where a length of the encoded sequence is N₁, N₁ is n times 1944, and n is an integer greater than or equal to 2; and outputting the encoded sequence.

In this embodiment of this application, the parity check matrix is applicable to the information bit sequence whose code length is n times 1944, where n is an integer greater than or equal to 2. Therefore, transmission reliability of a system can be improved, and decoding performance can be improved. Generally, a longer applicable code length indicates better reliability of the parity check matrix and better decoding performance.

According to a second aspect, an embodiment of this application provides a decoding method. The method is applied to a second communication apparatus, the second communication apparatus includes a Wi-Fi device, or a chip, a functional module, or the like that may be disposed in the Wi-Fi device, and the method includes:
obtaining to-be-decoded information, where a length of the to-be-decoded information is N₁, N₁ is n times 1944, and n is an integer greater than or equal to 2; and performing low-density parity-check LDPC decoding on the to-be-decoded information based on a parity check matrix, to obtain an information bit sequence.

With reference to the first aspect or the second aspect, in a possible implementation, the parity check matrix is determined based on a reference parity check matrix, a code length N₀ corresponding to the reference parity check matrix is less than or equal to 1944, and a coding rate corresponding to the reference parity check matrix is the same as a coding rate corresponding to the parity check matrix.

With reference to the first aspect or the second aspect, in a possible implementation, Z₁(i, j) and Z₀(i, j) satisfy a modulo operation relationship, where Z₁(i, j) represents an element in an iₜₕ row and a jₜₕ column in a matrix that corresponds to an information bit and that is in a matrix prototype of the parity check matrix, and Z₀(i, j) represents an element in an iₜₕ row and a jₜₕ column in a matrix that corresponds to the information bit and that is in a matrix prototype of the reference parity check matrix.

With reference to the first aspect or the second aspect, in a possible implementation, Z₁(i, j)=Z₀(i, j) or Z₁(i, j)=Z₀(i, j)+Z₀, where Z₀ represents an expansion factor of the reference parity check matrix, and Z₀=M₀/24.

With reference to the first aspect or the second aspect, in a possible implementation, a matrix corresponding to a parity bit in the matrix prototype of the parity check matrix is the same as a matrix corresponding to a parity bit in the matrix prototype of the reference parity check matrix.

With reference to the first aspect or the second aspect, in a possible implementation, N₁=3888.

With reference to the first aspect or the second aspect, in a possible implementation, the coding rate corresponding to the parity check matrix includes any one of the following: 1/2, 2/3, 3/4, or 5/6.

According to a third aspect, an embodiment of this application provides a first communication apparatus, configured to perform the method in the first aspect or any possible implementation. The communication apparatus includes a module configured to perform the method in the first aspect or any possible implementation.

According to a fourth aspect, an embodiment of this application provides a second communication apparatus, configured to perform the method in the second aspect or any possible implementation. The second communication apparatus includes a module configured to perform the method in the second aspect or any possible implementation.

According to a fifth aspect, an embodiment of this application provides a first communication apparatus. The first communication apparatus includes a processor configured to perform the method in the first aspect or any possible implementation. The processor is configured to execute a program stored in a memory. When the program is executed, the method in the first aspect or any possible implementation is performed.

In a possible implementation, the memory is located outside the first communication apparatus.

In a possible implementation, the memory is located inside the first communication apparatus.

In this embodiment of this application, the processor and the memory may alternatively be integrated into one component. In other words, the processor and the memory may alternatively be integrated together. For example, the first communication apparatus may be a chip.

In a possible implementation, the first communication apparatus further includes a transceiver. The transceiver is configured to receive information or send information.

According to a sixth aspect, an embodiment of this application provides a second communication apparatus. The second communication apparatus includes a processor configured to perform the method in the second aspect or any possible implementation. The processor is configured to execute a program stored in a memory. When the program is executed, the method in the second aspect or any possible implementation is performed.

In a possible implementation, the memory is located outside the second communication apparatus.

In a possible implementation, the memory is located inside the second communication apparatus.

In this embodiment of this application, the processor and the memory may alternatively be integrated into one component. In other words, the processor and the memory may alternatively be integrated. For example, the second communication apparatus may be a chip.

In a possible implementation, the second communication apparatus further includes a transceiver. The transceiver is configured to receive information or send information.

According to a seventh aspect, an embodiment of this application provides a first communication apparatus. The first communication apparatus includes a logic circuit and an interface. The logic circuit is coupled to the interface. The interface is configured to input and/or output information. The logic circuit is configured to perform the method according to the first aspect or any possible implementation.

According to an eighth aspect, an embodiment of this application provides a second communication apparatus. The second communication apparatus includes a logic circuit and an interface. The logic circuit is coupled to the interface. The interface is configured to input and/or output information. The logic circuit is configured to perform the method according to the second aspect or any possible implementation.

According to a ninth aspect, an embodiment of this application provides a computer-readable storage medium. The computer-readable storage medium is configured to store a computer program, and when the computer program is run on a computer, the method in any one of the first aspect and the second aspect or any possible implementation is performed.

According to a tenth aspect, an embodiment of this application provides a computer program product. When the computer program product is run on a computer, the method in any one of the first aspect and the second aspect or any possible implementation is performed.

According to an eleventh aspect, an embodiment of this application provides a computer program. When the computer program is run on a computer, the method in any one of the first aspect and the second aspect or any possible implementation is performed.

According to a twelfth aspect, an embodiment of this application provides a communication system. The communication system includes a first communication apparatus and a second communication apparatus, the first communication apparatus is configured to perform the method according to the first aspect or any possible implementation of the first aspect, and the second communication apparatus is configured to perform the method according to the second aspect or any possible implementation of the second aspect.

### BRIEF DESCRIPTION OF DRAWINGS

FIG. 1a is a diagram of a matrix prototype of a reference parity check matrix according to an embodiment of this application;
FIG. 1b is a diagram of a CPM according to an embodiment of this application;
FIG. 2a is a diagram of an architecture of a communication system according to an embodiment of this application;
FIG. 2b is a diagram of an architecture of a communication system according to an embodiment of this application;
FIG. 2c is a diagram of an architecture of a communication system according to an embodiment of this application;
FIG. 3 is a schematic flowchart of an encoding method and a decoding method according to an embodiment of this application;
FIG. 4 is a partial diagram of a shortening operation in LDPC encoding according to an embodiment of this application;
FIG. 5a is a diagram of two options when a modulo operation relationship is satisfied according to an embodiment of this application;
FIG. 5b is a diagram of tree expansion according to an embodiment of this application;
FIG. 6a is a diagram of a parity check matrix according to an embodiment of this application;
FIG. 6b is a diagram of a factor graph according to an embodiment of this application;
FIG. 7a is a diagram of a simulation result according to an embodiment of this application;
FIG. 7b is a diagram of a simulation result according to an embodiment of this application;
FIG. 7c is a diagram of a simulation result according to an embodiment of this application;
FIG. 7d is a diagram of a simulation result according to an embodiment of this application;
FIG. 8 is a diagram of a structure of a communication apparatus according to an embodiment of this application;
FIG. 9 is a diagram of a structure of a communication apparatus according to an embodiment of this application; and
FIG. 10 is a diagram of a structure of a communication apparatus according to an embodiment of this application.

### DESCRIPTION OF EMBODIMENTS

For ease of understanding technical solutions in this application, the following further describes this application with reference to accompanying drawings.

Terms "first", "second", and the like in the specification, claims, and accompanying drawings of this application are merely used to distinguish between different objects, and are not used to describe a specific order. In addition, terms such as "include" and "have" and any other variants thereof are intended to cover a non-exclusive inclusion. For example, processes, methods, systems, products, or devices that include a series of steps or units are not limited to listed steps or units, but instead, optionally further include steps or units that are not listed, or optionally further include other steps or units inherent to these processes, methods, products, or devices.

"Embodiments" mentioned herein mean that specific features, structures, or characteristics described in combination with the embodiments may be included in at least one embodiment of this application. The phrase shown in various locations in the specification may not necessarily refer to a same embodiment, and is not an independent or optional embodiment exclusive from another embodiment. It may be understood explicitly and implicitly by a person skilled in the art that the embodiments described herein may be combined with other embodiments.

In this application, "at least one (item)" means one or more, "a plurality of" means two or more, "at least two (items)" means two or three or more, and "and/or" is used to describe an association relationship between associated objects, which indicates that three relationships may exist. For example, "A and/or B" may indicate: only A exists, only B exists, and both A and B exist. A and B may be singular or plural. "Or" indicates that two relationships may exist, for example, only A exists and only B exists. When A and B are not mutually exclusive, it may indicate that three relationships exist, for example, only A exists, only B exists, and both A and B exist. The character "/" generally indicates an "or" relationship between the associated objects. "At least one of the following" or a similar expression thereof means any combination of these items. For example, at least one of a, b, or c may represent: a, b, c, "a and b", "a and c", "b and c", or "a and b and c".

An LDPC code is a quasi-cyclic (quasi cyclic, QC) LDPC (QC-LDPC) code used in the IEEE 802.11ac/ax standard. The QC-LDPC code is a structured LDPC code that is widely used. A parity check matrix of the QC-LDPC code has a unique structure, and encoding may be implemented by using a simple feedback shift register. Therefore, a problem of encoding complexity of the LDPC code can be well resolved.

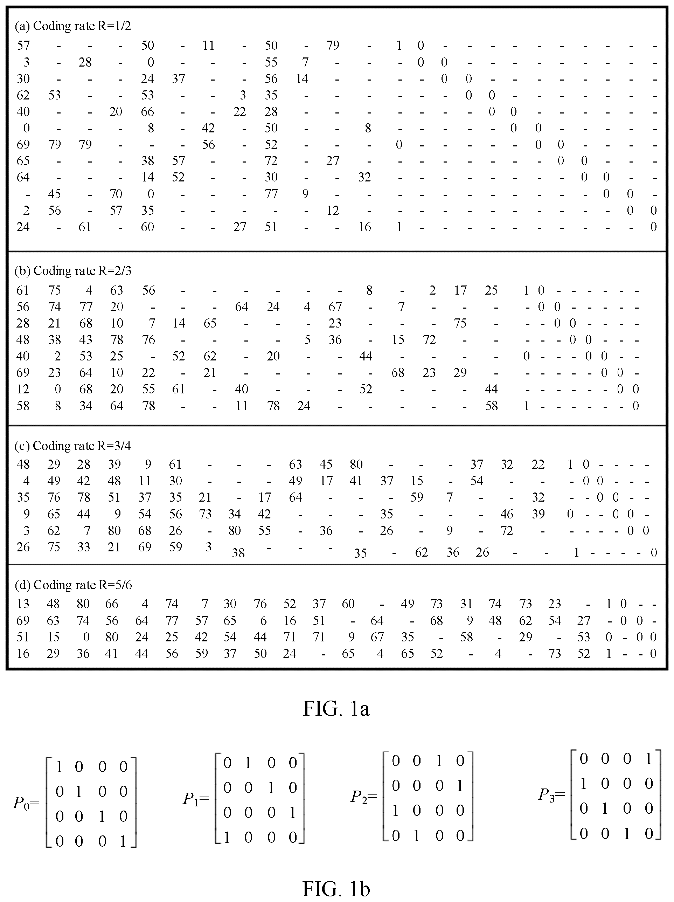

Currently, a total of 12 LDPC code parity check matrices are used in the standard. There are three types of code lengths N: N=648, N=1296, or N=1944. Each code length may support four different coding rates (codingrate): 1/2, 2/3, 3/4, and 5/6. A matrix prototype of a parity check matrix with each code length and coding rate is different, and parity bit parts (a matrix corresponding to a parity bit or a parity check matrix shown below) in matrix prototypes of the 12 parity check matrices with different code lengths and coding rates have a same structure. For example, a coding rate may be determined by a current transmission system according to a modulation and coding scheme (modulation and coding scheme, MCS) selected by link adaptation. Therefore, in a conventional WLAN, a communication apparatus may select a parity check matrix from the 12 parity check matrices based on a given code length and a given coding rate. The foregoing having a same structure may be understood as that in the parity bit part in the matrix prototypes of the different parity check matrices in FIG. 1a, elements in the first row and the first column are all 1, and elements in the last row and the first column are all 1.

FIG. 1a shows matrix prototypes of parity check matrices of LDPC codes with a code length N of 1944 and different coding rates. "-" in FIG. 1a represents an all-zero matrix of Z×Z, "0" in FIG. 1a represents an identity matrix of Z×Z, and a non-zero element in FIG. 1a represents a circulant permutation matrix (circulant permutation matrix, CPM) of the identity matrix of Z×Z. For example, the CPM is represented by Pᵢ, and i represents a circulant permutation value, a quantity of right circulant permutation bits of the identity matrix, a CPM coefficient, or an element greater than or equal to 0 in the matrix prototype of the parity check matrix. A specific name of i is not limited in this embodiment of this application. i is a non-negative integer, for example, 0 ≤ i ≤ Z - 1. When i=0, the CPM may be understood as the identity matrix of Z×Z, or the CPM whose circulant permutation value is 0. For example, Z=N/24. The foregoing "24" may be the same as a quantity of columns of a matrix prototype of a parity check matrix in the IEEE 802.11ac/ax standard. For IEEE 801.11ac/ax, whether the code length is N=648, N=1296, or N=1944, the quantity of columns of the matrix prototype of the parity check matrix is 24.

For example, an element "1" (that is, i=1) in FIG. 1a is used as an example, and the element 1 may be expanded to the CPM of 81×81 (1944/24=81). The CPM may be obtained by expanding the identity matrix and performing right circulant permutation by 1 bit on the identity matrix, as shown in the following: $\left[\begin{matrix}0 & 1 & 0 & ⋯ & 0 \\ 0 & 0 & 1 & ⋯ & 0 \\ ⋮ & ⋮ & ⋮ & ⋱ & ⋮ \\ 0 & 0 & 0 & ⋯ & 1 \\ 1 & 0 & 0 & ⋯ & 0\end{matrix}\right]$

For example, the CPM of 4×4 is used as an example. FIG. 1b shows the CPM when i=0, the CPM when i=1, the CPM when i=2, and the CPM when i=3. The CPM shown in FIG. 1b is merely an example. For the CPM of another identity matrix of Z×Z in this embodiment of this application, final Pᵢ may be obtained with reference to the principle shown in FIG. 1a or FIG. 1b. Details are not described herein again.

Because an LDPC code can improve transmission reliability of a wireless transmission system, the LDPC code has been widely applied in the WLAN standard. To further improve data transmission reliability of a Wi-Fi system, an LDPC code with a longer code length may be considered in a current standard or a next-generation standard, so that an encoding module obtains stronger error control performance, and decoding performance of a decoding module is improved.

In view of this, embodiments of this application provide an encoding method, a decoding method, and an apparatus. The method relates to a new LDPC code, and the LDPC code can support a longer code length. A parity check matrix provided in embodiments of this application is applicable to a longer code length. For example, the parity check matrix is applicable to a code length that is n times 1944, where n is an integer greater than or equal to 2. In addition, the parity check matrix may further improve decoding performance. For example, considering implementation complexity of a new Wi-Fi system, the new LDPC long code provided in embodiments of this application involves a minor modification to an LDPC encoding module and an LDPC decoding module in existing Wi-Fi, so that implementation complexity of LDPC encoding and decoding can be reduced.

In embodiments of this application, each matrix shown below may be referred to as a prototype of the parity check matrix, a matrix prototype of the parity check matrix (matrixprototypesoftheparity-matrices), a matrix prototype for a codeword block length N (matrixprototypesforcodewordblocklength N), a mother matrix, or the like. A specific name of the matrix in embodiments of this application is not limited in embodiments of this application. Generally, a matrix that includes an element 0 and an element 1 and that is expanded based on Z and a circulant permutation value i is referred to as a parity check matrix. Therefore, each matrix shown below may also be referred to as a matrix before CPM expansion, and the like. Each matrix shown in Example 1 to Example 12 below may be referred to as a matrix prototype of a parity check matrix, and a matrix obtained through element expansion in each matrix shown in Example 1 to Example 12 may be referred to as the parity check matrix. For a specific expansion method, refer to the foregoing related descriptions in FIG. 1a. Specific content of an expanded parity check matrix is not enumerated in embodiments of this application.

A code length in embodiments of this application may also be referred to as a codeword block length (acodewordblocklength) or the like. A specific name of the code length is not limited in embodiments of this application. Z in embodiments of this application may be referred to as a sub-block size (subblocksize), an expansion factor, a lifting factor (lift factor), or the like. A specific name of Z is not limited in this embodiment of this application. For ease of description, the following uses an example in which Z is referred to as an expansion factor for description.

Generally, Z=N/24. However, as the standard progresses, a subsequent method for calculating Z may also change. This is not limited in embodiments of this application. For ease of understanding, in embodiments of this application, different letter parameters represent different meanings. For example, N represents a code length, Z represents an expansion factor, R represents a coding rate, K represents a quantity of information bits, and E represents a quantity of parity bits. However, letter parameters shown in embodiments of this application are merely examples, and should not be construed as a limitation on embodiments of this application.

The following describes a communication system in embodiments of this application.

Technical solutions provided in embodiments of this application may be applied to a wireless local area network (wireless local area network, WLAN) system, for example, Wi-Fi. The method provided in embodiments of this application is applicable to an IEEE 802.11 protocol family of the institute of electrical and electronics engineers, for example, the 802.11be protocol, the 802.11bn protocol, or a next-generation protocol of the 802.11bn protocol. Examples are not enumerated herein. The technical solutions provided in embodiments of this application may be further applied to a wireless personal area network (wireless personal area network, WPAN) based on millimeter wave (millimeter wave, MMW) and ultra-wideband (ultra-wideband, UWB) technologies. For example, the method provided in embodiments of this application may be applied to the IEEE 802.15 protocol family such as the 802.15.4a protocol, the 802.15.4z protocol, the 802.15.4ab protocol, or a future-generation UWB WPAN protocol. Examples are not enumerated herein. The technical solutions provided in embodiments of this application may be further applied to the following communication systems, for example, an internet of things (internet of things, IoT) system, vehicle-to-everything (vehicle-to-everything, V2X, where X may represent anything), device-to-device (device-to-device, D2D), a narrow band internet of things (narrow band internet of things, NB-IoT) system, a long term evolution (long term evolution, LTE) system, a 5th-generation (5th-generation, 5G) communication system, a new communication system emerging in future communication development, and the like. For example, the V2X may include vehicle-to-vehicle (vehicle-to-vehicle, V2V), vehicle-to-infrastructure (vehicle-to-infrastructure, V2I), vehicle-to-pedestrian (vehicle-to-pedestrian, V2P) communication, or vehicle-to-network (vehicle-to-network, V2N) communication.

The WLAN system may provide high-rate and low-latency transmission. With continuous evolution of WLAN application scenarios, the WLAN system is to be applied to more scenarios or industries, for example, an internet of things industry, an internet of vehicles industry, a banking industry, enterprise offices, stadiums and exhibition halls, concert halls, hotel rooms, dormitories, wards, classrooms, supermarkets, squares, streets, production workshops, and warehousing. Certainly, a device (for example, an access point or a station) that supports WLAN communication or sensing may be a sensor node (for example, a smart water meter, a smart electricity meter, or a smart air detection node) in a smart city, a smart device (for example, a smart camera, a projector, a display, a television, a speaker, a refrigerator, and a washing machine) in a smart home, an internet of things node, an entertainment terminal (for example, a wearable device like an augmented reality (augmented reality, AR) device or a virtual reality (virtual reality, VR) device), a smart device (for example, a printer, a projector, a loudspeaker, or a speaker) in smart office, an internet of vehicles device in the internet of vehicles, an infrastructure in a daily life scenario (for example, a vending machine, a self-service navigation console of a supermarket, a self-service cashier device, and a self-service ordering machine), a device in a large sports and music venue, and the like.

Although embodiments of this application mainly use a WLAN as an example, especially a network applied to IEEE 802.11 series standards, embodiments of this application may support Wi-Fi 8, which may also be referred to as ultra-high reliability (ultra-high reliability, UHR), ultra-high reliability and throughput (ultra-high reliability and throughput, UHRT), or the like. Examples are not enumerated herein. Various aspects in embodiments of this application may be expanded to other networks that use various standards or protocols, for example, Bluetooth (Bluetooth), a high performance radio LAN (high performance radio LAN, HIPERLAN) (a wireless standard similar to the IEEE 802.11 standard), a wide area network (wide area network, WAN), or other networks known or developed in the future.

In a possible implementation, the method provided in embodiments of this application may be implemented by a communication apparatus in a communication system. For example, the communication apparatus may be an access point (access point, AP) or a station (station, STA).

The AP is an apparatus having a wireless communication function, supports communication or sensing by using a WLAN protocol, has a function of communicating with or sensing another device (for example, a non-access point station (non-access point station, non-AP STA) or another access point) in a WLAN network, and certainly may further have a function of communicating with or sensing another device. Alternatively, the access point is equivalent to a bridge that connects a wired network and a wireless network. A main function of the access point is to connect various wireless network clients together and then connect the wireless network to the Ethernet. In a WLAN system, the access point may be referred to as an access point station (AP STA). The apparatus having the wireless communication function may be an entire device, or may be a chip, a processing system, a functional module, or the like mounted in the entire device. The device in which the chip, the processing system, or the functional module is mounted may implement a method, a function, and the like in embodiments of this application under control of the chip, the processing system, or the functional module. The AP in embodiments of this application is an apparatus that provides a service for the non-AP STA, and may support the 802.11 protocol family, subsequent protocols, or the like. For example, the access point may be an access point for a terminal (for example, a mobile phone) to access a wired (or wireless) network, and is mainly deployed in a home, a building, and a park. A typical coverage radius is tens to hundreds of meters. Certainly, the access point may alternatively be deployed outdoors. For another example, the AP may be a communication entity, for example, a communication server, a router, a switch, or a bridge, or the AP may include various forms of macro base stations, micro base stations, relay stations, and the like. Certainly, the AP may alternatively be a chip, a processing system, or a module in the foregoing devices in various forms, to implement a method and a function in embodiments of this application.

The STA is an apparatus having a wireless communication function, supports communication or sensing by using a WLAN protocol, and has a capability of communicating with or sensing another non-AP STA or access point in a WLAN. In a WLAN system, the station may be referred to as a non-access point station (non-access point station, non-AP STA). For example, the STA is any user communication device that allows a user to communicate with or sense the AP and then communicate with the WLAN. The apparatus having the wireless communication function may be an entire device, or may be a chip, a processing system, a functional module, or the like mounted in the entire device. The device in which the chip, the processing system, or the functional module is mounted may implement a method, a function, and the like in embodiments of this application under control of the chip, the processing system, or the functional module. For example, the STA may be a wireless communication chip, a wireless sensor, or a wireless communication terminal, and may also be referred to as a user. For another example, the STA may be a mobile phone that supports a Wi-Fi communication function, a tablet computer that supports a Wi-Fi communication function, a set-top box that supports a Wi-Fi communication function, a smart television that supports a Wi-Fi communication function, a smart wearable device that supports a Wi-Fi communication function, a vehicle-mounted communication device that supports a Wi-Fi communication function, or a computer that supports a Wi-Fi communication function. Certainly, the STA may alternatively be a chip, a processing system, or a module in the foregoing devices in various forms, to implement a method and a function in embodiments of this application.

For example, a communication system to which the method provided in embodiments of this application may be applied may include an access point and a station. For example, embodiments of this application may be applied to a scenario of communication or sensing between an AP and a STA, between APs, or between STAs in a WLAN. This is not limited in embodiments of this application. Optionally, the AP may communicate with or sense a single STA, or the AP may simultaneously communicate with or sense a plurality of STAs. Specifically, communication or sensing between the AP and the plurality of STAs may be classified into downlink transmission in which the AP simultaneously sends signals to the plurality of STAs and uplink transmission in which the plurality of STAs send signals to the AP. A WLAN communication protocol may be supported between an AP and a STA, between APs, or between STAs. The communication protocol may include an IEEE 802.11 protocol family, for example, the 802.11bn protocol. Certainly, protocols subsequent to 802.11bn may also be supported.

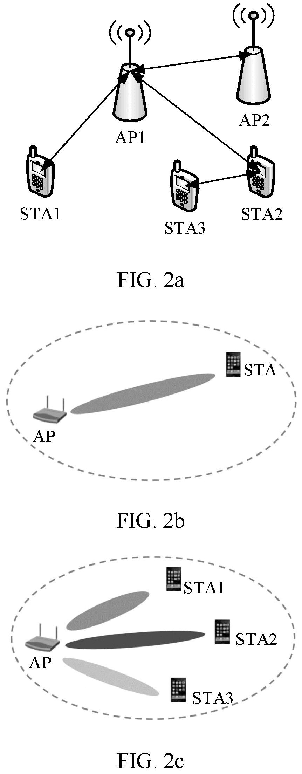

FIG. 2a is a diagram of an architecture of a communication system according to an embodiment of this application. The communication system may include one or more APs and one or more STAs. FIG. 2a shows two access points such as an AP 1 and an AP 2, and three stations such as a STA 1, a STA 2, and a STA 3. In an example, the method provided in this embodiment of this application is applicable to data communication or sensing between one AP and one or more STAs, for example, communication between the AP 1 and the STA 1 shown in FIG. 2a, communication between an AP and a STA shown in FIG. 2b, communication between the AP 1 and the STA 1 and communication between the AP 1 and the STA 2 shown in FIG. 2a, and communication between an AP and a STA 1, a STA 2, and a STA 3 shown in FIG. 2c. In another example, the method provided in this embodiment of this application is applicable to communication between APs, for example, communication between the AP 1 and the AP 2 shown in FIG. 2a. In still another example, the method provided in this embodiment of this application is applicable to communication between STAs, for example, communication between the STA 2 and the STA 3 shown in FIG. 2a.

In FIG. 2a to FIG. 2c, an example in which the STA is a mobile phone and the AP is a router is used. This does not mean that types of the AP and the STA in this embodiment of this application are limited. In addition, a quantity of APs and a quantity of STAs shown in FIG. 2a to FIG. 2c are merely examples. In specific implementation, the quantity of APs or the quantity of STAs may be greater or less. This is not limited in this embodiment of this application.

From different perspectives of sending a signal and receiving a signal, in the following content, a first communication apparatus may be understood as a communication apparatus that sends a signal, and a second communication apparatus may be understood as a communication apparatus that receives a signal. Alternatively, the first communication apparatus may also be referred to as a transmit end, and the second communication apparatus may also be referred to as a receive end. In this embodiment of this application, the signal may be a signal obtained after an encoded sequence is processed. From a perspective of different devices, in an example, the first communication apparatus and the second communication apparatus may be Wi-Fi chips, functional modules, processing systems, or the like disposed in different Wi-Fi devices. In another example, the first communication apparatus may be an AP, and the second communication apparatus may be a non-AP STA. In still another example, both the first communication apparatus and the second communication apparatus may be non-AP STAs or APs. In still another example, the first communication apparatus may be a non-AP STA, and the second communication apparatus may be an AP. In still another example, at least one of the first communication apparatus and the second communication apparatus may be a multi-link device (multi-link device, MLD), or the like. Examples are not enumerated in embodiments of this application. For example, the multi-link device (multi-link device, MLD) means that the device simultaneously has a plurality of stations (for example, APs or non-AP STAs), which operate on different frequency bands or channels. The multi-link device includes a plurality of affiliated stations. The affiliated stations may be physical stations, or may be logical stations. Each station may operate on one link, one frequency band, one channel, or the like. The affiliated station may be an AP or a non-AP STA. The multi-link device (for example, a non-AP MLD or an AP MLD) may be a communication apparatus having a wireless communication function. The communication apparatus may be an entire device, or may be a chip, a processing system, a module, or the like mounted in the entire device. The device in which the chip, the processing system, or the module is mounted may implement a method and a function in embodiments of this application under control of the chip, the processing system, or the module. The multi-link device may implement wireless communication in compliance with an 802.11 protocol family, to communicate with another device. The another device may be a multi-link device, or may not be a multi-link device. Frequency bands on which the multi-link device operates may include but are not limited to sub 1 GHz, 2.4 GHz, 5 GHz, 6 GHz, and the like. Examples are not enumerated herein.

In embodiments of this application, the method provided in embodiments of this application is described from two sides: the first communication apparatus and the second communication apparatus. However, in a process in which the first communication apparatus and the second communication apparatus transmit a signal, the signal may be further forwarded by using another apparatus, for example, the signal between the first communication apparatus and the second communication apparatus is forwarded by using a forwarding apparatus. An apparatus other than the first communication apparatus and the second communication apparatus is not limited in embodiments of this application.

The following describes methods in embodiments of this application.

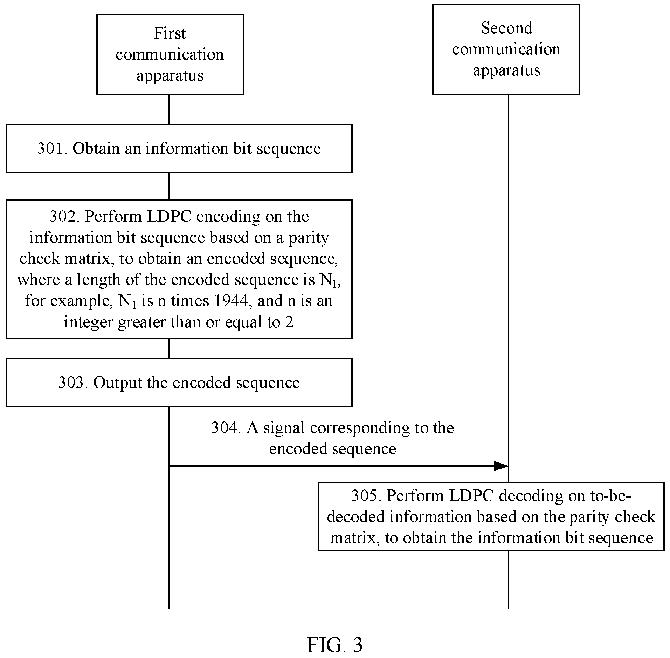

FIG. 3 is a schematic flowchart of an encoding method and a decoding method according to an embodiment of this application. For descriptions of the first communication apparatus and the second communication apparatus, refer to the foregoing descriptions. Details are not described herein again. As shown in FIG. 3, the method includes the following steps.

301. A first communication apparatus obtains an information bit sequence.

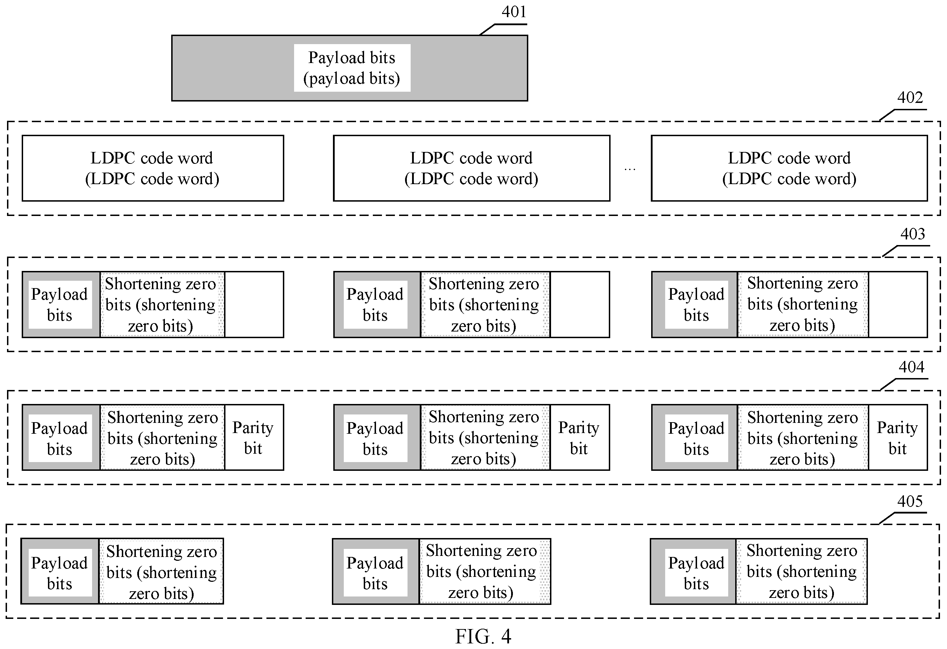

The information bit sequence may be a bit sequence that includes an information amount. For example, a length of the information bit sequence is N₂, or a quantity of bits in the information bit sequence is N₂. N₂ is a positive integer. The N₂ bits may include K information bits, referred to as K data bits, or referred to as K payload bits (payloadbits). K is a positive integer. N₂ may be an integer greater than or equal to K. For example, when N₂ is greater than K, the information bit sequence may further include (N₂-K) 0s. For related descriptions of "0" shown herein, refer to the following descriptions of a shortening operation in FIG. 4. Details are not described herein again.

A value of N₂ may be related to a code length and a coding rate. In the following step 302, if a length of an encoded sequence is N₁, N₂=N₁×R, and R is an encoding coding rate of the information bit sequence. N₁ shown herein may also be referred to as a code length corresponding to a parity check matrix.

In a possible implementation, the method shown in FIG. 3 may further include the following step.

The first communication apparatus obtains the code length N₁.

In an example, N₁ may be m times 1296, and m is an integer greater than or equal to 2. For example, N₁=1296×2=2592. For another example, N₁=1296×3=3888. Examples are not enumerated herein.

In another example, N₁ may be n times 1944, and n is an integer greater than or equal to 2. For example, N₁=1944×2=3888, or N₁=1944×3=5832. Examples are not enumerated herein.

In a possible implementation, the method shown in FIG. 3 may further include the following step.

The first communication apparatus obtains the coding rate R.

In a WLAN system, different code lengths and coding rates may correspond to different parity check matrices. Therefore, before performing LDPC encoding, the first communication apparatus may further obtain the coding rate R. After obtaining the coding rate R, the first communication apparatus may select the parity check matrix based on the coding rate R and the code length N₁. The coding rate R may be determined based on an MCS selected by link adaptation. For example, the coding rate R may be determined based on current channel information. A specific method for determining the coding rate R is not limited in this embodiment of this application. In an example, the MCS may be delivered by an AP. In another example, the MCS may be determined by the first communication apparatus, or the like. For example, the first communication apparatus sends the MCS to a second communication apparatus, and the second communication apparatus receives the MCS, and learns of the coding rate R based on the MCS. For another example, the second communication apparatus sends the MCS to the first communication apparatus, and the first communication apparatus receives the MCS, and learns of the coding rate R based on the MCS. A specific interaction procedure of the MCS is not limited in this embodiment of this application.

For example, R may be any one of the following: 1/2, 2/3, 3/4, or 5/6. Certainly, with progress of the standard, a value of R may be another value subsequently. This is not limited in this embodiment of this application.

The encoded sequence may include K information bits and E parity bits. Alternatively, the encoded sequence may include the information bit sequence and a parity bit sequence. The length of the information bit sequence may be N₂, and a length of the parity bit sequence may be E. N₁=N₂+E. A value of E is related to N₁ and R. For example, if N₁=3888 and R=1/2, E=1944. For another example, if N₁=3888 and R=2/3, E=3888×1/3=1296. For another example, if N₁=3888 and R=3/4, E=3888×1/4=972. For another example, if N₁=3888 and R=5/6, E=3888×1/6=648.

302. The first communication apparatus performs LDPC encoding on the information bit sequence based on the parity check matrix, to obtain the encoded sequence. The length of the encoded sequence is N₁. For example, N₁ is n times 1944, and n is an integer greater than or equal to 2.

The following describes a matrix prototype of the parity check matrix in this embodiment of this application.

In the matrix prototype of the parity check matrix shown below, "-1" represents an all-zero matrix of Z₁×Z₁, "0" represents an identity matrix of Z₁×Z₁, and a non-zero element represents a CPM of the identity matrix of Z₁×Z₁. "-1" in the parity check matrix shown below may also be replaced with "-". For descriptions of parameters, the CPM, and the like, refer to the foregoing descriptions. Details are not described herein again. The following "1" in Example 1, "2" in Example 2, or "3" in Example 3 is used to distinguish between different examples and facilitate subsequent reference.

In Example 1, the matrix prototype of the parity check matrix may be the following matrix:

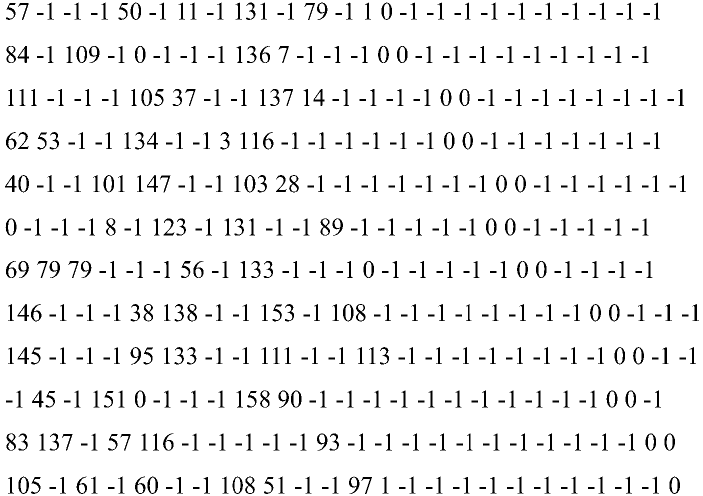

In another Example 2, the matrix prototype of the parity check matrix may be the following matrix:

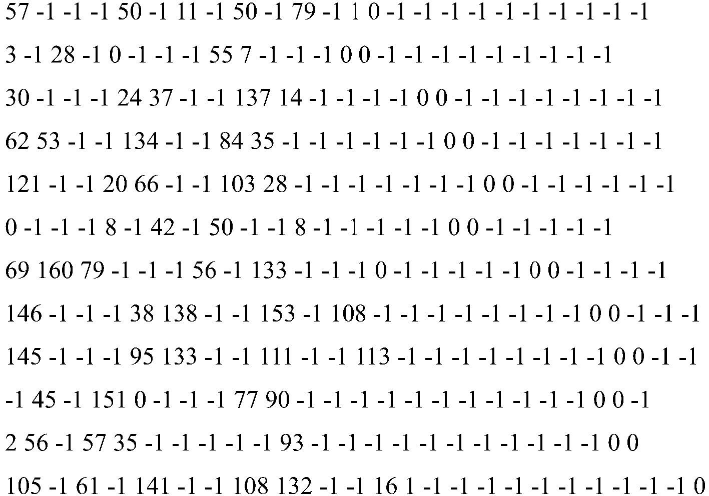

In still another Example 3, the matrix prototype of the parity check matrix may be the following matrix:

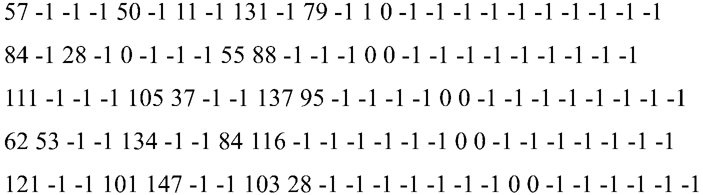

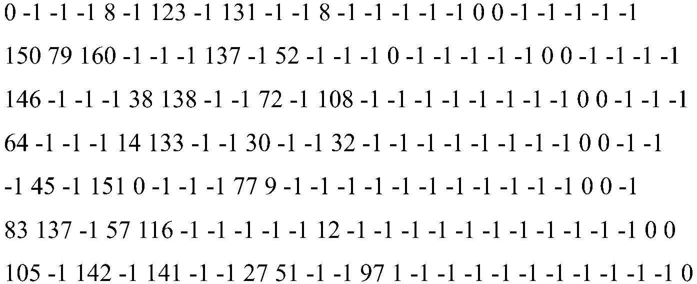

R corresponding to the matrix prototypes of the parity check matrices shown in Example 1 to Example 3 may be equal to 1/2. In addition, R corresponding to the parity check matrix is also equal to 1/2. For example, N₁ corresponding to the matrix prototype of the parity check matrices shown in Example 1 to Example 3 may be equal to 3888. In addition, N₁ corresponding to the parity check matrix is also equal to 3888.

For example, an expansion factor Z₁=N₁/24=3888/24=162. An element i in Example 1 to Example 3 may be expanded to the CPM, and the CPM is obtained by performing right circulant permutation by i bits on the identity matrix. For example, the element 0 in Example 1 to Example 3 may be expanded to the identity matrix of 162×162, and the element i greater than 0 (for example, i is greater than 0) may perform right circulant permutation by i bits on the identity matrix to obtain the CPM of 162×162. The matrix prototypes shown in Example 1 to Example 3 include 12 rows and 24 columns. Therefore, the parity check matrix expanded based on the expansion factor Z₁ may include 12×162 rows and 24×162 columns. Related descriptions of the expansion factor Z₁ herein are also applicable to the following Example 4 to Example 12. Details are not described below again.

For ease of description, in the following, the first X columns in the matrix prototype of the parity check matrix are referred to as a square matrix corresponding to the information bit, an information square matrix, or an information bit part of an LDPC codeword, and the last Y columns in the matrix prototype of the parity check matrix are referred to as a matrix corresponding to the parity bit, or a parity check square matrix, or a parity bit part of the LDPC codeword. X and Y are positive integers. For example, X=24×R. Y=24× (1-R). For example, for the matrix prototypes shown in Example 1 to Example 3, X=12, and Y=12.

In an example, when K=3888×1/2=1944, that is, when the information bit sequence includes 1944 information bits, the encoded sequence may include the 1944 information bits and 1944 parity bits.

In another example, when K is less than 1944, that is, a quantity of information bits included in the information bit sequence is less than 1944, the encoded sequence may include the K information bits and the 1944 parity bits. Although the encoded sequence includes the K information bits and the 1944 parity bits, the length of the encoded sequence is N₁. As shown in FIG. 4, because the quantity of information bits is less than 1944, before performing LDPC encoding, the first communication apparatus may obtain the information bit sequence by filling in a specific quantity of 0s, and then discard these 0s after completing the LDPC encoding. For example, the quantity of 0s may be equal to 1944-K. For related descriptions of the shortening operation, refer to FIG. 4. Details are not described herein again.

In still another example, when the quantity of to-be-sent information bits obtained before the first communication apparatus obtains the information bit sequence is greater than 1944, the first communication apparatus may perform codeword division processing on the information bit before performing LDPC encoding. For example, after the codeword division processing, a plurality of codewords (or referred to as blocks or segments) may be obtained, and a quantity of information bits carried in each codeword may be less than or equal to 1944. For specific descriptions of codeword division processing, refer to a related standard or protocol. This is not limited in this embodiment of this application. Certainly, after performing codeword division processing, the first communication apparatus may further perform the shortening operation in combination. The combination of the shortening operation and the codeword division operation is not described herein again.

Related descriptions of different values of K herein are also applicable to the following Example 4 to Example 12. Details are not described below again.

In Example 4, the matrix prototype of the parity check matrix may be the following matrix:

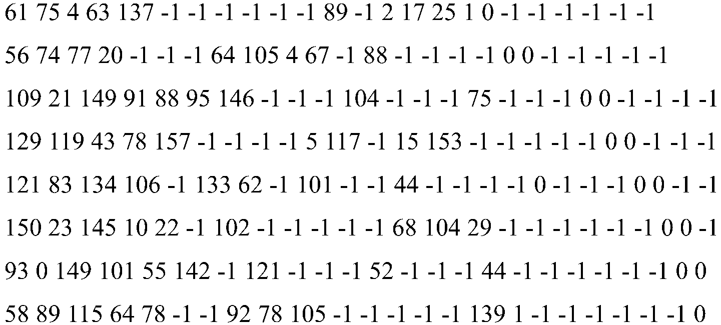

In Example 5, the matrix prototype of the parity check matrix may be the following matrix:

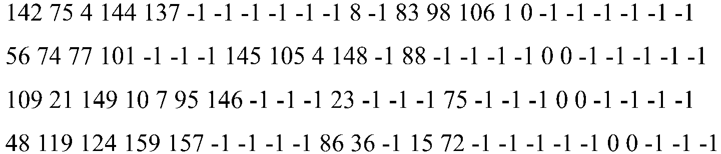

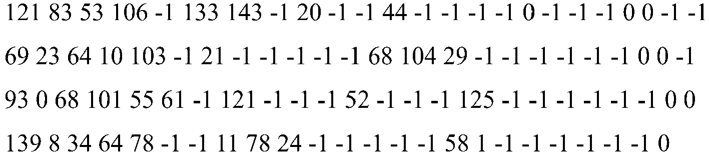

In Example 6, the matrix prototype of the parity check matrix may be the following matrix:

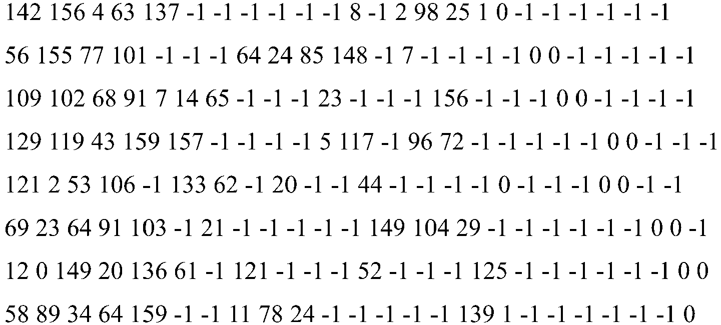

R corresponding to the matrix prototypes of the parity check matrices shown in Example 4 to Example 6 may be equal to 2/3. In addition, R corresponding to the parity check matrix is also equal to 2/3. For example, N₁ corresponding to the matrix prototypes of the parity check matrices shown in Example 4 to Example 6 may be equal to 3888. In addition, N₁ corresponding to the parity check matrix is also equal to 3888.

For related descriptions of the expansion factor Z₁, refer to the descriptions in Example 1 to Example 3. Details are not described herein again.

For Example 4 to Example 6, X=24×2/3=16, and Y=24×1/3=8. For related descriptions of X and Y, refer to Example 1 to Example 3. Details are not described herein again.

For related descriptions of a relationship between different values of K and 2592 (3888×2/3=2592), refer to Example 1 to Example 3. Details are not described herein again.

In Example 7, the matrix prototype of the parity check matrix may be the following matrix:

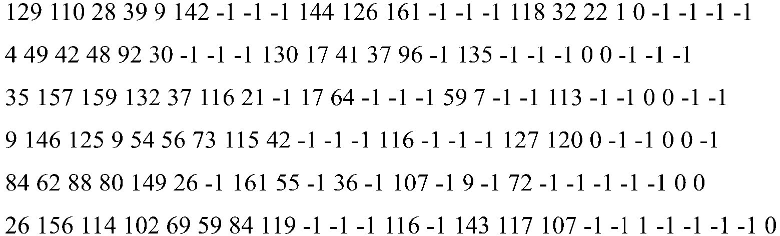

In Example 8, the matrix prototype of the parity check matrix may be the following matrix:

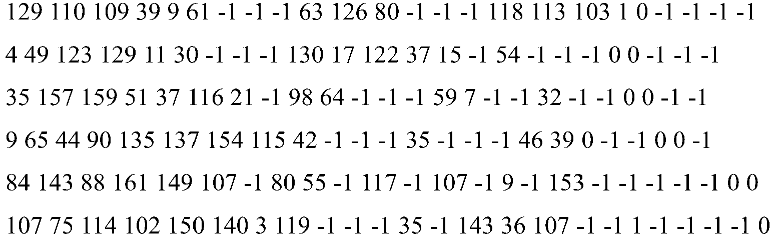

In Example 9, the matrix prototype of the parity check matrix may be the following matrix:

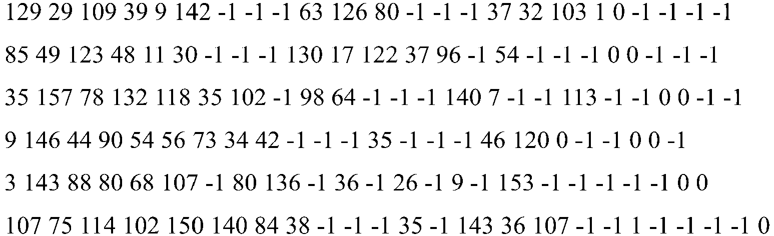

R corresponding to the matrix prototypes of the parity check matrices shown in Example 7 to Example 9 may be equal to 3/4. In addition, R corresponding to the parity check matrix is also equal to 3/4. For example, N₁ corresponding to the matrix prototypes of the parity check matrices shown in Example 7 to Example 9 may be equal to 3888. In addition, N₁ corresponding to the parity check matrix is also equal to 3888.

For related descriptions of the expansion factor Z₁, refer to the descriptions in Example 1 to Example 3. Details are not described herein again.

For Example 7 to Example 9, X=24×3/4=18, and Y=24×1/4=6. For related descriptions of X and Y, refer to Example 1 to Example 3. Details are not described herein again.

For related descriptions of a relationship between different values of K and 2916 (3888×3/4=2916), refer to Example 1 to Example 3. Details are not described herein again.

In Example 10, the matrix prototype of the parity check matrix may be the following matrix:

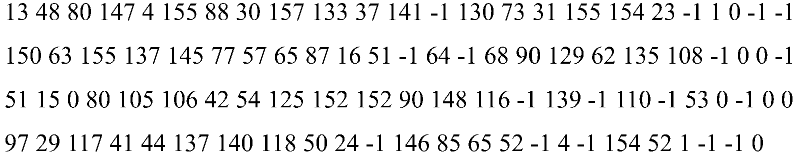

In Example 11, the matrix prototype of the parity check matrix may be the following matrix:

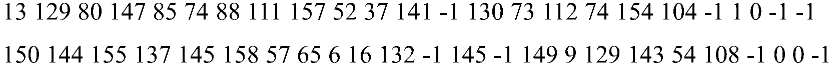

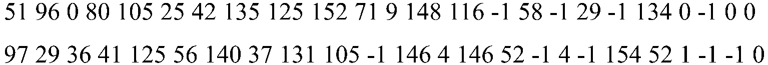

In Example 12, the matrix prototype of the parity check matrix may be the following matrix:

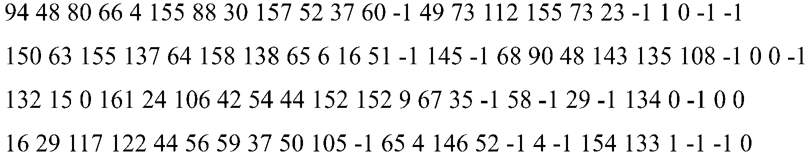

R corresponding to the matrix prototypes of the parity check matrices shown in Example 10 to Example 12 may be equal to 5/6. In addition, R corresponding to the parity check matrix is also equal to 5/6. For example, N₁ corresponding to the matrix prototypes of the parity check matrices shown in Example 10 to Example 12 may be equal to 3888. In addition, N₁ corresponding to the parity check matrix is also equal to 3888.

For related descriptions of the expansion factor Z₁, refer to the descriptions in Example 1 to Example 3. Details are not described herein again.

For Example 10 to Example 12, X=24×5/6=20, and Y=24×1/6=4. For related descriptions of X and Y, refer to Example 1 to Example 3. Details are not described herein again.

For related descriptions of a relationship between different values of K and 3240 (3888×5/6=3240), refer to Example 1 to Example 3. Details are not described herein again.

The matrix prototypes of the parity check matrices shown in Example 1 to Example 12 are merely examples. The matrix prototypes of the parity check matrices shown in this embodiment of this application may alternatively obtain another matrix prototype by using the following determining methods. Examples are not enumerated herein.

303. The first communication apparatus outputs the encoded sequence.

For example, the first communication apparatus may perform LDPC encoding by using an encoding module (for example, an LDPC encoding module), to obtain the encoded sequence, and output the encoded sequence from the encoding module. For related descriptions of the length of the encoded sequence, refer to step 301 or step 302. Details are not described herein again.

In a possible implementation, after outputting the encoded sequence, the first communication apparatus may further perform a shortening operation. The following uses examples for description.

Generally, after being encoded, the information bit sequence needs to be placed into an integer quantity of orthogonal frequency division multiplexing (orthogonal frequency division multiplexing, OFDM) symbols, and the encoded sequence also needs to be placed into an integer quantity of LDPC codewords. Therefore, before the first communication apparatus performs LDPC encoding, the first communication apparatus further needs to first determine a minimum quantity N_{SYM} of OFDM symbols required for the current transmission, and then calculate, based on N_{SYM} and a current coding and modulation scheme (for example, a modulation order indicated by the MCS), a total quantity N_{TCB} of encoded bits that can be stored in all OFDM symbols is N_{CBPS}×N_{SYM}, where N_{CBPS} is a quantity of encoded bits that can be stored in each OFDM symbol. Then, the first communication apparatus may calculate, based on the foregoing obtained result, an LDPC code length (namely, the code length shown in this embodiment of this application) used for the current transmission and a quantity N_{CW} of required codewords. For example, when there are not enough information bits (for example, in the following cases in which K is less than 1944 shown in Example 1 to Example 3) that can fill the information bit part of the LDPC codeword, the first communication apparatus may perform the shortening operation before performing LDPC encoding (which may also be referred to as generating the parity bit). The shortening operation means that before the parity bit is generated through LDPC encoding, a specific quantity of 0s are filled in the information bit part, and the 0s are discarded after the parity bit is generated through encoding. FIG. 4 is a partial diagram of a shortening operation in LDPC encoding according to an embodiment of this application. As shown in FIG. 4, step 401 indicates that the first communication apparatus may obtain a to-be-coded payload bit (payload bits) (for example, the K information bits shown in this embodiment of this application). Step 402 indicates that the first communication apparatus may calculate the LDPC code length and the quantity of codewords. FIG. 4 shows an example of three LDPC codewords. A length (namely, a code length) of each LDPC codeword (LDPC code word) may be equal to the code length. Step 403 indicates that the first communication apparatus may perform the shortening operation on the information bit. FIG. 4 shows a codeword including a load bit and a shortening zero bit (shortening zero bits). Step 404 indicates that the first communication apparatus may generate the parity bit (parity bits) by using the payload bit and a shortening bit. FIG. 4 shows a codeword including the payload bit, the shortening 0 bit, and the parity bit. Step 405 indicates that the first communication apparatus discards the shortening 0 bit (discard shortening bits). FIG. 4 shows a codeword including the data bit and the parity bit. The foregoing related descriptions of the shortening operation are merely examples. For related descriptions of the shortening operation, refer to a related standard or protocol. This is not limited in this embodiment of this application.

304. The first communication apparatus sends a signal corresponding to the encoded sequence, and the second communication apparatus receives the signal.

The foregoing signal corresponding to the encoded sequence is a processed signal transmitted by the first communication apparatus through a channel after the encoded sequence is output from the encoding module and other processing may be performed on the encoded sequence. For example, the first communication apparatus may further perform at least one of the following processing on the encoded sequence: stream parsing, constellation mapping, LDPC sub-carrier mapping, stream circulant permutation, spatial and frequency mapping, inverse discrete fourier transform (inverse discrete fourier transform, IDFT), and cyclic prefix insertion and windowing (insertGI andwindow). For example, after receiving the signal transmitted through the channel, the second communication apparatus may perform corresponding processing on the signal. For example, before obtaining to-be-decoded information, the second communication apparatus may perform at least one of the following processing: cyclic prefix removal, discrete fourier transform (discrete fourier transform, DFT), spatial and frequency demapping, de-interleaving, and constellation demapping.

For example, the first communication apparatus may also perform rate matching on the encoded sequence. A rate matching method includes puncturing, repetition, and shortening. For example, the first communication apparatus may also puncture the parity bit in the encoded sequence, to obtain a higher coding rate or a shorter code length. For other processing performed by the first communication apparatus on the encoded sequence and corresponding processing performed before the second communication apparatus obtains the to-be-decoded information, refer to a related standard or protocol. This is not limited in this embodiment of this application. A length of the to-be-decoded information may be N₁. For example, the to-be-decoded information may include a bit, a real number, or the like. Specific content included in the to-be-decoded information is not limited in this embodiment of this application. For example, before obtaining the to-be-decoded information, the second communication apparatus may further supplement a shortening bit, for example, supplement the shortening bit with reference to the code length and K, or may further supplement a puncturing bit. This is not limited in this embodiment of this application.

305. The second communication apparatus performs LDPC decoding on the to-be-decoded information based on the parity check matrix, to obtain the information bit sequence.

For example, a decoding method that may be used by the second communication apparatus includes but is not limited to a hard-decision decoding method, a soft-decision decoding method, or a hybrid decoding method. A specific decoding process is not described in detail in this embodiment of this application.

For example, the second communication apparatus may alternatively determine the code length N₁ by using a method similar to the method in FIG. 4. For related descriptions of how the second communication apparatus learns of the code length N₁ and the coding rate R, refer to the foregoing descriptions of the first communication apparatus. Details are not described herein again.

For a method for learning of N₁ and R by the first communication apparatus and a method for learning of N₁ and R by the second communication apparatus, refer to a related standard or protocol. This is not limited in this embodiment of this application.

In this embodiment of this application, step 301 to step 303 may be implemented by the encoding module, and step 305 may be implemented by a decoding module. In specific implementation, the method shown in FIG. 3 may be further divided into the encoding method or the decoding method. For example, the encoding method may include step 301 to step 303, and the first communication apparatus may include the encoding module. For example, the decoding method may include step 305, and the second communication apparatus may include the decoding module. Optionally, in addition to the foregoing encoding module, the first communication apparatus may further include an obtaining module. The obtaining module may be configured to obtain the code length, the coding rate, and the like. Optionally, the first communication apparatus may further include a shortening module, a block division module, or the like. Optionally, in addition to the decoding module, the second communication apparatus may further include an obtaining module. The obtaining module may be configured to obtain the to-be-decoded information.

In this embodiment of this application, the parity check matrix is applicable to the information bit sequence whose code length is n times 1944, where n is an integer greater than or equal to 2. Therefore, transmission reliability of the system can be improved, and decoding performance can be improved.

The following describes a method for determining the parity check matrix in this embodiment of this application.

The method for determining the parity check matrix shown in this embodiment of this application is merely an example. In specific implementation, the following determining method may be defined by a standard. Alternatively, in specific implementation, the two communication parties may not perform the determining method shown below. For example, the two communication parties may store the matrix prototype of the parity check matrix, store a circulant permutation value, or store indication information. Although the foregoing shows the matrix prototypes of the 12 parity check matrices as an example, a matrix prototype of another parity check matrix determined based on the determining method shown in this embodiment of this application also fall within the protection scope of this embodiment of this application.

The following determining method is shown by using an example of a reference parity check matrix whose code length N₀=1944. As shown in step 301 above, N₁ may also be m times 1296. That is, based on the determining method shown below, the parity check matrix whose code length is greater than 1944 may also be determined based on the parity check matrix corresponding to the code length of 1296. According to the determining method shown below, the parity check matrix whose code length is greater than 1944 determined by using the parity check matrix corresponding to the code length of 1296 as the reference parity check matrix also falls within the protection scope of this embodiment of this application.

The following uses an example in which a matrix prototype of the reference parity check matrix is the matrix shown in FIG. 1a to describe a method for determining the matrix prototype of the parity check matrix in this embodiment of this application. Certainly, a name of the reference parity check matrix shown in this embodiment of this application is merely an example. For example, the reference parity check matrix may also be referred to as a base parity check matrix, an original parity check matrix, or the like.

The reference parity check matrix is described as follows:

The code length N₀ corresponding to the reference parity check matrix is 1944, and the coding rate includes 1/2, 2/3, 3/4, and 5/6. An expansion factor Z₀ of the reference parity check matrix is 1944/24=81.

When R=1/2, the matrix prototype of the reference parity check matrix is a matrix whose size is 12×24, that is, the matrix prototype of the reference parity check matrix includes 12 rows and 24 columns. The reference parity check matrix expanded based on the matrix prototype may include 972 rows and 1944 columns. X=12, and Y=12.

When R=2/3, the matrix prototype of the reference parity check matrix is a matrix whose size is 8×24, that is, the matrix prototype of the reference parity check matrix includes 8 rows and 24 columns. The reference parity check matrix expanded based on the matrix prototype may include 648 rows and 1944 columns. X=16, and Y=8.

When R=3/4, the matrix prototype of the reference parity check matrix is a matrix whose size is 6×24, that is, the matrix prototype of the reference parity check matrix includes 6 rows and 24 columns. The reference parity check matrix expanded based on the matrix prototype may include 648 rows and 1944 columns. X=18, and Y=6.

When R=5/6, the matrix prototype of the reference parity check matrix is a matrix whose size is 4×24, that is, the matrix prototype of the reference parity check matrix includes 4 rows and 24 columns. The reference parity check matrix expanded based on the matrix prototype may include 324 rows and 1944 columns. X=20, and Y=4.

The parity check matrix is described as follows:

The code length N₁ corresponding to the parity check matrix is 3888, and the coding rate includes 1/2, 2/3, 3/4, and 5/6. The expansion factor Z₁ of the parity check matrix is 3888/24=162.

When R=1/2, the matrix prototype of the parity check matrix is a matrix whose size is 12×24, that is, the matrix prototype of the parity check matrix includes 12 rows and 24 columns. The parity check matrix expanded based on the matrix prototype includes 1944 rows and 3888 columns. X=12, and Y=12.

When R=2/3, the matrix prototype of the parity check matrix is a matrix whose size is 8×24, that is, the matrix prototype of the parity check matrix includes 8 rows and 24 columns. The parity check matrix expanded based on the matrix prototype includes 1296 rows and 3888 columns. X=16, and Y=8.

When R=3/4, the matrix prototype of the parity check matrix is a matrix whose size is 6×24, that is, the matrix prototype of the parity check matrix includes 6 rows and 24 columns. The parity check matrix expanded based on the matrix prototype includes 972 rows and 3888 columns. X=18, and Y=6.

When R=5/6, the matrix prototype of the parity check matrix is a matrix whose size is 4×24, that is, the matrix prototype of the parity check matrix includes 4 rows and 24 columns. The parity check matrix expanded based on the matrix prototype includes 648 rows and 3888 columns. X=20, and Y=4.

In this embodiment of this application, for a same coding rate, an element Z₁(i, j) in an information square matrix in the matrix prototype of the parity check matrix and an element Z₀(i, j) in an information square matrix in the matrix prototype of the reference parity check matrix satisfy a modulo operation relationship. For example, Z₀(i, j) and Z₁(i, j) may satisfy the following relationship: Z₀(i, j)=Z₁(i, j) %Z₀, or Z₀(i, j) =Z₁(i, j) % (Z₁/2). It can be learned from the foregoing descriptions of X and Y that Z₁(i, j) shown herein is an element in a matrix corresponding to the first X columns in the matrix prototype of the parity check matrix, and Z₀(i, j) is an element in a matrix corresponding to the first X columns in the matrix prototype of the reference parity check matrix.

For example, that the two satisfy a modulo operation relationship includes Z₁(i, j)=Z₀(i, j), or Z₁(i, j)=Z₀(i, j)+Z₀.

For example, Z₀(i, j) in the matrix prototype (for example, the first matrix shown in FIG. 1a) of the reference parity check matrix when N₀=1944 and R=1/2 and Z₁(i, j) in the matrix prototype (as described in Example 1 to Example 3) of the parity check matrix when N₁=3888 and R=1/2 satisfy the modulo operation relationship. For example, if i=1 and j=1, Z₀ (1, 1)=57. For the foregoing Example 1, Z₁ (1, 1)= 57, that is, Z₁(1, 1)=Z₀(1, 1), satisfying the modulo operation relationship. For example, if i=2 and j=1, Z₀ (2, 1)=3. For the foregoing Example 1, Z₁(2, 1)=84, that is, Z₁(2, 1)=Z₀ (2, 1)+81, satisfying the modulo operation relationship. For the foregoing Example 2, Z₁(2, 1)=3, and Z₁ (2, 1)=Z₀ (2, 1), satisfying the modulo operation relationship. Specific examples that satisfy the modulo operation relationship are not enumerated herein.

For another example, Z₀(i, j) in the matrix prototype (for example, the second matrix shown in FIG. 1a) of the reference parity check matrix when N₀=1944 and R=2/3 and Z₁(i, j) in the matrix prototype of the parity check matrix (as described in Example 4 to Example 6 above) when N₁=3888 and R=2/3 satisfy the modulo operation relationship.

For another example, Z₀(i, j) in the matrix prototype (for example, the third matrix shown in FIG. 1a) of the reference parity check matrix when N₀=1944 and R=3/4 and Z₁(i, j) in the matrix prototype (as described in Example 7 to Example 9 above) of the parity check matrix when N₁=3888 and R=3/4 satisfy the modulo operation relationship.

For another example, Z₀(i, j) in the matrix prototype (for example, the fourth matrix shown in FIG. 1a) of the reference parity check matrix when N₀=1944 and R=5/6 and Z₁(i, j) in the matrix prototype (as described in Example 10 to Example 12 above) of the parity check matrix when N1=3888 and R=5/6 satisfy the modulo operation relationship.

In this embodiment of this application, for a same coding rate, an element Y₁(i, j) in the parity check square matrix in the matrix prototype of the parity check matrix is the same as an element Y₀(i, j) in a parity check square matrix in the matrix prototype of the reference parity check matrix. Y₁(i, j) shown herein is an element in a matrix corresponding to the last Y columns in the matrix prototype of the parity check matrix, and Y₀(i, j) is an element in a matrix corresponding to the last Y columns in the matrix prototype of the reference parity check matrix.

For example, a matrix corresponding to the last Y columns in the matrix prototype of the parity check matrix when N₀=3888 and R=1/2 is the same as a matrix corresponding to the last Y columns in the matrix prototype of the reference parity check matrix when N₀=1944 and R=1/2. That is, a value of each element (or referred to as each CPM coefficient) in the parity check square matrix in the matrix prototype of the parity check matrix is the same as a value of an element at a corresponding location in the parity check square matrix in the matrix prototype of the reference parity check matrix.

For another example, a matrix corresponding to the last Y columns in the matrix prototype of the parity check matrix when N₀=3888 and R=2/3 is the same as a matrix corresponding to the last Y columns in the matrix prototype of the reference parity check matrix when N₀=1944 and R=2/3.

For another example, a matrix corresponding to the last Y columns in the matrix prototype of the parity check matrix when N₀=3888 and R=3/4 is the same as a matrix corresponding to the last Y columns in the matrix prototype of the reference parity check matrix when N₀=1944 and R=3/4.

For another example, a matrix corresponding to the last Y columns in the matrix prototype of the parity check matrix when N₀=3888 and R=5/6 is the same as a matrix corresponding to the last Y columns in the matrix prototype of the reference parity check matrix when N₀=1944 and R=5/6.

In this embodiment of this application, Z₀(i, j) and Z₁(i, j) satisfy a nesting relationship, that is, Z₀(i, j) and Z₁(i, j) satisfy the modulo operation relationship, the parity check square matrix of the matrix prototype of the parity check matrix is the same as the parity check square matrix of the matrix prototype of the reference parity check matrix, and a size of the matrix prototype of the parity check matrix is the same as a size of the matrix prototype of the reference parity check matrix. In this way, the parity check matrix whose code length is greater than 1944 provided in this embodiment of this application can reduce a modification to the existing LDPC encoding module and the existing LDPC decoding module in the Wi-Fi system as much as possible, to reduce implementation complexity of encoding and decoding. For example, although the code length of the parity check matrix provided in this embodiment of this application is n times 1944 (that is, the code length of the parity check matrix shown in this embodiment of this application is greater than the longest code length in the current Wi-Fi system), the parity check matrix is determined based on the reference parity check matrix whose code length is 1944. Therefore, when performing LDPC encoding, the first communication apparatus may still reuse the existing LDPC encoding module. When performing LDPC decoding, the second communication apparatus may still reuse the existing LDPC decoding module. In this embodiment of this application, modifications to the LDPC encoding module and the LDPC decoding module are reduced, and decoding performance is further ensured.

In this embodiment of this application, Z₀(i, j) and Z₁(i, j) satisfy the modulo operation relationship. In an example, the two communication parties (for example, the first communication apparatus and the second communication apparatus) store each element in the matrix prototype of the parity check matrix. For example, each element in the matrix prototype of the parity check matrix is stored, and when the code length is 3888, the two communication parties may directly obtain the parity check matrix based on the elements stored by the two communication parties. For another example, each element in the matrix prototype of the parity check matrix is stored, and when the code length is 1944, the two communication parties may obtain the reference parity check matrix based on the foregoing modulo operation relationship. In other words, the two communication parties may obtain LDPC codes with two code lengths by storing each element (or referred to as each CPM coefficient or circulant permutation value) in the matrix prototype of the parity check matrix, to save storage space. In another example, the two communication parties may further store the reference parity check matrix and the indication information. The indication information indicates whether each element in the information square matrix in the matrix prototype of the parity check matrix satisfies Z₁(i, j)=Z₀(i, j) or Z₁(i, j)=Z₀(i, j)+Z₀. For example, the indication information may be a bitmap, and each bit in the bitmap may indicate whether one element in the information matrix is Z₁ (i, j) =Z₀ (i, j) or Z₁ (i, j) =Z₀ (i, j) +Z₀. For example, if a value of a bit is 0, an element corresponding to the bit satisfies Z₁(i, j)=Z₀(i, j). For another example, if the value of a bit is 1, it is indicated that an element corresponding to the bit satisfies Z₁(i, j)=Z₀(i, j) +Z₀. For example, the indication information may alternatively be in a form of a binary matrix. For example, a size of the binary matrix may be the same as a size of a matrix corresponding to the first X columns. For example, the binary matrix may include an element 0 and an element 1. The element 0 may indicate that an element in a parity check matrix corresponding to a location of the element 0 satisfies Z₁(i, j)=Z₀(i, j), and the element 1 may indicate that an element in a parity check matrix corresponding to a location of the element 1 satisfies Z₁(i, j)=Z₀(i, j) +Z₀.

Further, on the basis that Z₀(i, j) and Z₁(i, j) satisfy the modulo operation relationship and the parity check square matrix in the matrix prototype of the parity check matrix is the same as the parity check square matrix in the matrix prototype of the reference parity check matrix, an embodiment of this application further provides a determining method. Based on the determining method shown below, a parity check matrix with better decoding performance can be effectively filtered out, and decoding performance of the parity check matrix is ensured.

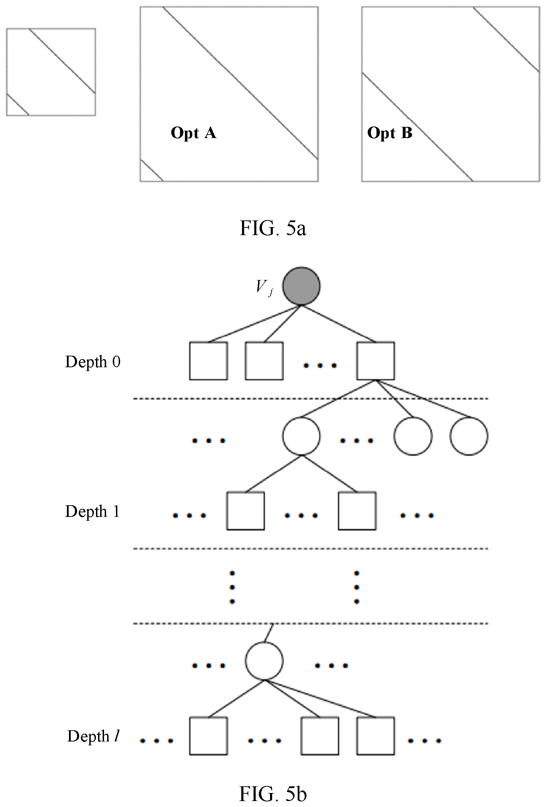

For example, the matrix prototype of the parity check matrix may be further determined based on a tree structure. To ensure the foregoing modulo operation relationship, there are two options for Z₀(i, j) of each non-negative 1 item, for example, if Z₀(i, j)=s, Z₁(i, j)=s(keep unchanged) or Z₁(i, j)=s+Z₀. In FIG. 5a, a small square may represent a value of Z₀(i, j), an option A (Opt A) may represent Z₁(i, j)=s(keep unchanged), and an option B (Opt B) represents Z₁(i, j)=s+Z₀.

Specific selection of Opt A or Opt B for Z₁(i, j) may depend on expanding Z₁(i, j) numerically, where an option with a greater depth is selected. A specific diagram of tree expansion is shown in FIG. 5b. A circle represents a variable node, and a square represents a check node. A greater depth of an expanded tree indicates fewer short cycles included in an obtained corresponding matrix, and the short cycle have a negative impact on decoding performance. If each variable node performs tree expansion, each Opt A or Opt B in a corresponding matrix may correspond to a different depth, and a cycle structure caused in a factor graph (tanner graph) corresponding to the entire parity check matrix is also different. Therefore, in this embodiment of this application, a local cycle structure and an overall cycle structure of the matrix are comprehensively considered, and all non-zero elements are designed based on tree expansion, to ensure that the factor graph corresponding to the parity check matrix has a relatively good cycle structure. Based on the foregoing method, it can be effectively ensured that the parity check matrix provided in this embodiment of this application can maintain a fast and efficient encoding manner of an original WLAN LDPC code.

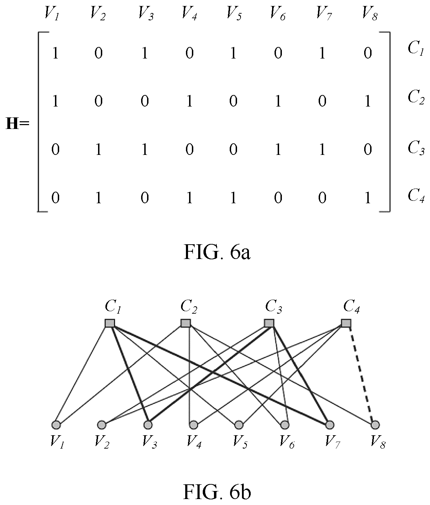

The factor graph and the parity check matrix are in a one-to-one correspondence. The factor graph consists of two types of nodes. The first type of node is a variable node, indicating an information bit. The second type of node is a check node, indicating a check constraint. Each check node represents a check constraint. FIG. 6a shows the parity check matrix H of the LDPC code. In FIG. 6a, {Vi} represents a variable node set, and {Cj} represents a check node set. i=1,2, ..., 8. j=1, 2, 3, 4. Each row of the parity check matrix H corresponds to one check equation, and each column corresponds to one information bit. In FIG. 6a, there are eight variable nodes and four check nodes. If an information bit is included in a corresponding check equation, a related variable node and check node are connected by using a connection line, to obtain a factor graph. FIG. 6b is the factor graph of the parity check matrix H of the LDPC code. For other descriptions of the factor graph, refer to a related standard or protocol. This is not limited in this embodiment of this application.

The following describes a simulation result of the parity check matrix provided in this embodiment of this application.

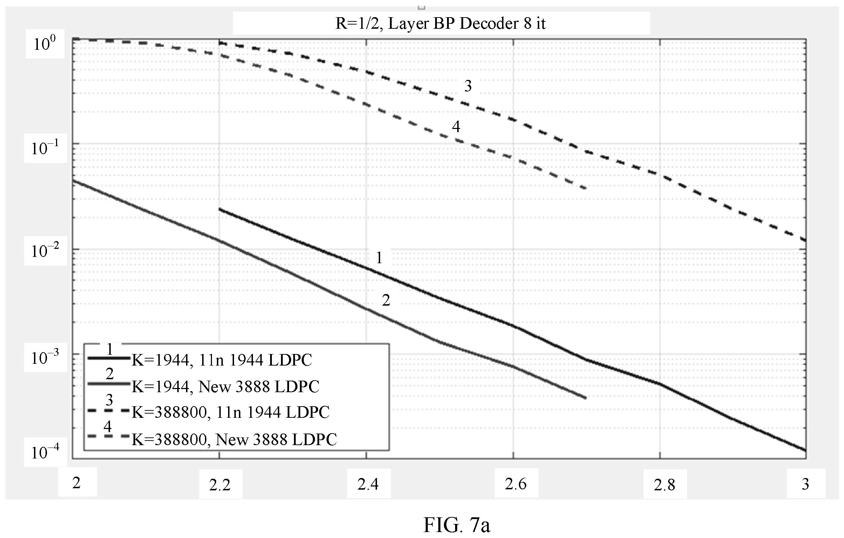

The following separately provides performance comparison between the foregoing parity check matrix and the reference parity check matrix. In FIG. 7a to FIG. 7d, a horizontal coordinate represents a signal-to-noise ratio (signal-to-noise ratio, SNR), and a unit is dB. A vertical coordinate represents a block error rate (block error rate, BLER). The decoding method is a soft-decision decoding method, for example, a brief propagation (brief propagation, BP) algorithm, and a quantity of decoding iterations is 8. Sequence numbers 1 to 4 in FIG. 7a to FIG. 7d are set for ease of distinguishing different curves, and should not be construed as a limitation on this embodiment of this application.

FIG. 7a shows a performance comparison between a parity check matrix of a code length of 3888 and a reference parity check matrix of a code length of 1944. R=1/2.

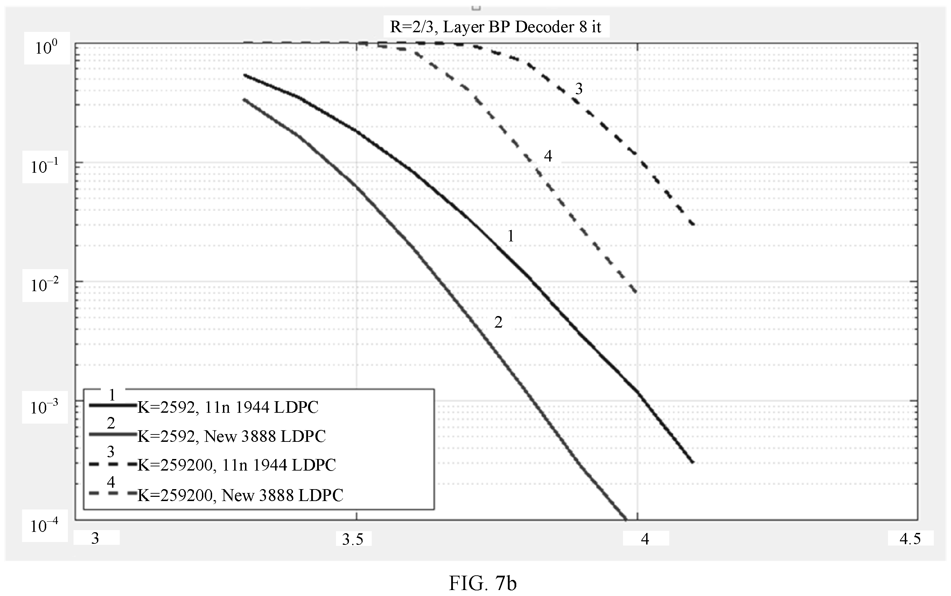

FIG. 7b shows a performance comparison between a parity check matrix of a code length of 3888 and a reference parity check matrix of a code length of 1944. R=2/3.

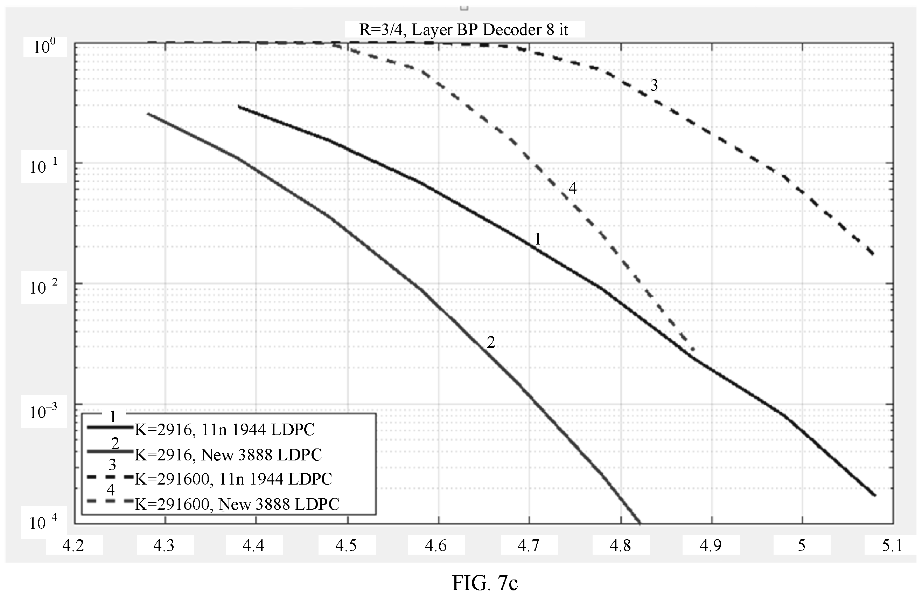

FIG. 7c shows a performance comparison between a parity check matrix of a code length of 3888 and a reference parity check matrix of a code length of 1944. R=3/4

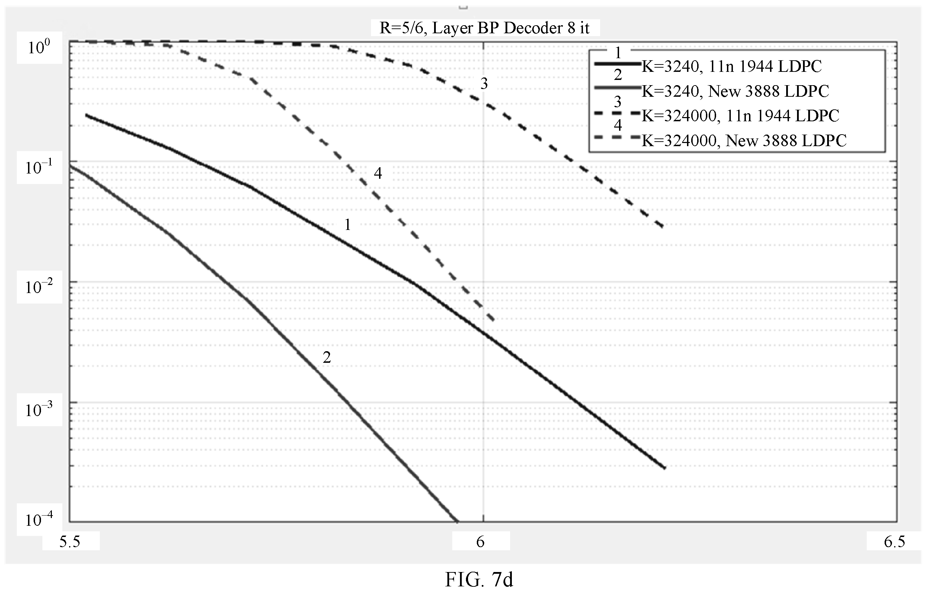

FIG. 7d shows a performance comparison between a parity check matrix of a code length of 3888 and a reference parity check matrix of a code length of 1944. R=5/6.

It can be learned from the foregoing that under a same SNR, a BLER corresponding to the parity check matrix is lower. Therefore, decoding performance of the parity check matrix is better. Therefore, each parity check matrix provided in this embodiment of this application can achieve significant improvement in decoding performance, and good trade-off may be achieved between decoding performance and complexity.

A communication apparatus provided in an embodiment of this application is described below.

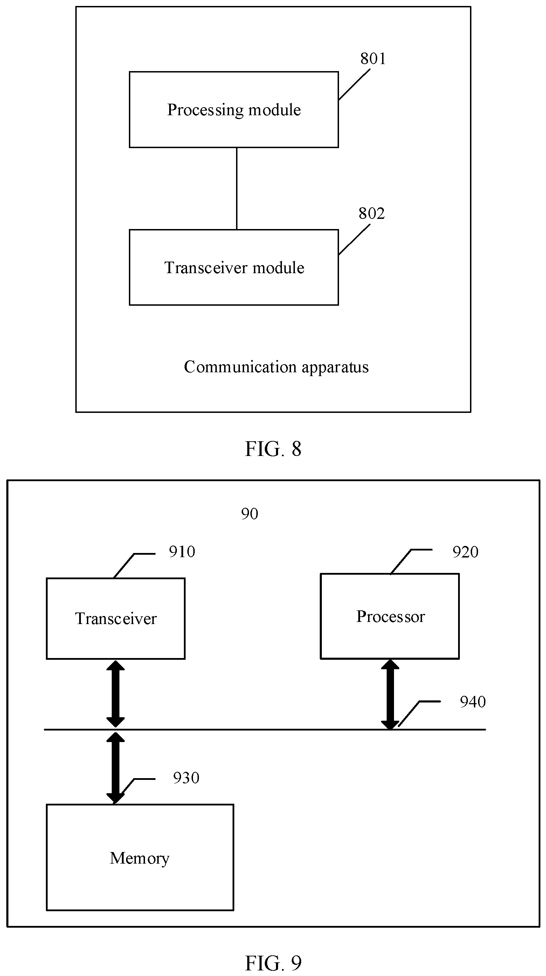

In this application, the communication apparatus is divided into functional modules based on the foregoing method embodiments. For example, each functional module may be divided to each corresponding function, or two or more functions may be integrated into one processing module. The integrated module may be implemented in a form of hardware, or may be implemented in a form of a software functional module. It should be noted that, in this application, module division is an example, and is merely a logical function division. In actual implementation, another division manner may be used. The following describes in detail a communication apparatus in embodiments of this application with reference to FIG. 8 to FIG. 10.

FIG. 8 is a diagram of a structure of a communication apparatus according to an embodiment of this application. As shown in FIG. 8, the communication apparatus includes a processing module 801 and a transceiver module 802. The transceiver module 802 may implement a corresponding communication function, and the processing module 801 is configured to implement a corresponding processing function. For example, the transceiver module 802 may also be referred to as an interface, a communication interface, or a communication module.

In some embodiments of this application, the communication apparatus may be configured to perform an action performed by the first communication apparatus in the foregoing method embodiments. In this case, the first communication apparatus may be a Wi-Fi device, or a chip, a functional module, or the like that can be configured in the device. The transceiver module 802 is configured to perform a sending/receiving-related operation of the first communication apparatus in the foregoing method embodiments, and the processing module 801 is configured to perform a processing-related operation of the first communication apparatus in the foregoing method embodiments.

For example, the processing module 801 may be configured to: obtain an information bit sequence, and perform LDPC encoding on the information bit sequence based on a parity check matrix, to obtain an encoded sequence; and the transceiver module 802 may be configured to output the encoded sequence.

For example, the processing module 801 may be further configured to perform other processing on the encoded sequence; and the transceiver module 802 may be further configured to send or output a signal obtained through other processing.

For example, the processing module 801 may include an encoding module. For example, the processing module 801 may further include an obtaining module, a shortening module, a block division module, or the like. For example, the processing module 801 may further include at least one of the following modules: a constellation mapping module, a stream circulant permutation module, a spatial and frequency mapping module, an IDFT module, and a cyclic prefix insertion and windowing module. For example, the transceiver module 802 may include a radio frequency module, an antenna module, and the like. For example, the transceiver module 802 may include a pin module.

FIG. 8 is reused. In some other embodiments of this application, the communication apparatus may be configured to perform an action performed by the second communication apparatus in the foregoing method embodiments. In this case, the communication apparatus may be a Wi-Fi device, or a chip, a functional module, or the like that can be configured in the device. The transceiver module 802 is configured to perform a sending/receiving-related operation of the second communication apparatus in the foregoing method embodiments, and the processing module 801 is configured to perform a processing-related operation of the second communication apparatus in the foregoing method embodiments.

For example, the transceiver module 802 may be configured to receive or input a signal transmitted through a channel; and the processing module 801 may be configured to process the signal to obtain to-be-decoded information.

For example, the transceiver module 802 may be configured to input the to-be-decoded information; and the processing module 801 may perform LDPC decoding on the to-be-decoded information based on the parity check matrix, to obtain the information bit sequence.

For example, the processing module 801 may include a decoding module. For example, the processing module 801 may further include an obtaining module and the like. For example, the processing module 801 may further include at least one of the following components: a cyclic prefix removal module, a DFT module, a deinterleaving module, a constellation demapping module, and a descrambling module. For example, the transceiver module 802 may include a radio frequency module, an antenna module, and the like. For example, the transceiver module 802 may include a pin module.

Optionally, in the foregoing embodiments, the communication apparatus may further include a storage module. The storage module may be configured to store instructions and/or data. The processing module 801 may read the instructions and/or the data in the storage module, so that the communication apparatus implements the foregoing method embodiments. For example, the storage module may further store the CPM coefficient, the indication information, or the like in the matrix prototype of the parity check matrix shown above.

In the foregoing embodiments, for specific descriptions of terms or steps such as the reference parity check matrix, the parity check matrix, the prototype of the parity check matrix, the prototype of the reference parity check matrix, the CPM, the circulant permutation shift amount, the expansion factor, the code length, and the coding rate, refer to the descriptions in the foregoing method embodiments. Details are not described herein again.

Specific descriptions of the transceiver module and the processing module shown in the foregoing embodiments are merely examples. For specific functions or steps performed by the transceiver module and the processing module, refer to the foregoing method embodiments. Details are not described herein again.

The foregoing describes the communication apparatus in embodiments of this application. The following describes a possible product form of the communication apparatus. Any form of product that has a function of the communication apparatus in FIG. 8 falls within the protection scope of embodiments of this application. The following descriptions are merely examples, and the product form of the communication apparatus in embodiments of this application is not limited thereto.

In a possible implementation, in the communication apparatus shown in FIG. 8, the processing module 801 may be one or more processors, and the transceiver module 802 may be a transceiver; or the transceiver module 802 may be a sending module and a receiving module, the sending module may be a transmitter, the receiving module may be a receiver, and the sending module and the receiving module are integrated into one device, for example, a transceiver. In embodiments of this application, the processor and the transceiver may be coupled, or the like. A connection manner between the processor and the transceiver is not limited in embodiments of this application. In a process of performing the foregoing method, a process of sending information in the foregoing method may be a process of outputting the information by the processor. When outputting the information, the processor outputs the information to a transceiver, so that the transceiver transmits the information. After the information is outputted by the processor, other processing may further need to be performed on the information before the information arrives at the transceiver. Similarly, a process of receiving information in the foregoing method may be a process of receiving the input information by the processor. When the processor receives the input information, the transceiver receives the information and inputs the information to the processor. Further, after the transceiver receives the information, other processing may need to be performed on the information before the information is input into the processor.

As shown in FIG. 9, a communication apparatus 90 includes one or more processors 920 and a transceiver 910.

In some embodiments of this application, the communication apparatus may be configured to perform steps, methods, or functions performed by the first communication apparatus or a gateway server. For example, the processor 920 may be configured to perform functions or steps implemented by the processing module 801 shown in FIG. 8. The transceiver 910 may be configured to perform functions or steps implemented by the transceiver module 802 shown in FIG. 8. For specific descriptions of the processor 920 and the transceiver 910, refer to FIG. 8 or the foregoing method embodiments. Details are not described herein again.

In some other embodiments of this application, the communication apparatus is configured to perform steps, methods, or functions performed by the second communication apparatus or a terminal device. For example, the processor 920 may be configured to perform functions or steps implemented by the processing module 801 shown in FIG. 8. The transceiver 910 may be configured to perform functions or steps implemented by the transceiver module 802 shown in FIG. 8. For specific descriptions of the processor 920 and the transceiver 910, refer to FIG. 8 or the foregoing method embodiments. Details are not described herein again.

In each implementation of the communication apparatus shown in FIG. 9, the transceiver may include a receiver and a transmitter. The receiver is configured to perform a receiving function (or operation), and the transmitter is configured to perform a transmitting function (or operation). In addition, the transceiver is configured to communicate with another device/apparatus through a transmission medium.

Optionally, the communication apparatus 90 may further include one or more memories 930, configured to store program instructions and/or data. The memory 930 is coupled to the processor 920. The coupling in embodiments of this application may be an indirect coupling or a communication connection between communication apparatuses, units, or modules in an electrical form, a mechanical form, or another form, and is used for information exchange between the communication apparatuses, the units, or the modules. The processor 920 may operate in collaboration with the memory 930. The processor 920 may execute the program instructions stored in the memory 930. Optionally, at least one of the one or more memories may be included in the processor.

In this embodiment of this application, a specific connection medium among the transceiver 910, the processor 920 and the memory 930 is not limited. In this embodiment of this application, in FIG. 9, the memory 930, the processor 920, and the transceiver 910 are connected to each other through a bus 940. The bus is represented by using a thick line in FIG. 9. A manner of connection between other components is only schematically described, but is not used as a limitation. The bus may be classified into an address bus, a data bus, a control bus, and the like. For ease of representation, only one thick line is used to represent the bus in FIG. 9, but this does not mean that there is only one bus or only one type of bus.

In this embodiment of this application, the processor may be a general-purpose processor, a digital signal processor, an application-specific integrated circuit, a field programmable gate array or another programmable logic device, a discrete gate or transistor logic device, a discrete hardware component, or the like. The processor can implement or execute the methods, the steps, and the logical block diagrams disclosed in embodiments of this application. The general-purpose processor may be a microprocessor or any conventional processor or the like. The steps of the methods disclosed in combination with embodiments of this application may be directly implemented by a hardware processor, or may be implemented by using a combination of hardware and software modules in the processor, or the like.

In this embodiment of this application, the memory may include but is not limited to a nonvolatile memory such as a hard disk drive (hard disk drive, HDD) or a solid-state drive (solid-state drive, SSD), a random access memory (Random Access Memory, RAM), an erasable programmable ROM (Erasable Programmable ROM, EPROM), a read-only memory (Read-Only Memory, ROM), or a portable read-only memory (Compact Disc Read-Only Memory, CD-ROM). The memory is any storage medium that can be used to carry or store program code in a form of an instruction or a data structure and that can be read and/or written by a computer (for example, the communication apparatus shown in this application). However, this application is not limited thereto. The memory in embodiments of this application may alternatively be a circuit or any other apparatus that can implement a storage function, and is configured to store the program instructions and/or the data.

The processor 920 is mainly configured to process a communication protocol and communication data, control the entire communication apparatus, execute a software program, and process data of the software program. The memory 930 is mainly configured to store the software program and the data. The transceiver 910 may include a control circuit and an antenna. The control circuit is mainly configured to: perform conversion between a baseband signal and a radio frequency signal and process the radio frequency signal. The antenna is mainly configured to receive and send a radio frequency signal in a form of an electromagnetic wave. The input/output apparatus, such as a touchscreen, a display, or a keyboard, is mainly configured to: receive data input by a user and output data to the user.

After the communication apparatus is powered on, the processor 920 may read the software program in the memory 930, interpret and execute instructions of the software program, and process the data of the software program. When data needs to be sent wirelessly, the processor 920 performs baseband processing on the to-be-sent data, and then outputs a baseband signal to a radio frequency circuit. The radio frequency circuit performs radio frequency processing on the baseband signal, and then sends, through the antenna, a radio frequency signal in an electromagnetic wave form. When data is sent to the communication apparatus, the radio frequency circuit receives a radio frequency signal through the antenna, converts the radio frequency signal into a baseband signal, and outputs the baseband signal to the processor 920. The processor 920 converts the baseband signal into data, and processes the data.

In another implementation, the radio frequency circuit and the antenna may be disposed independent of the processor that performs baseband processing. For example, in a distributed scenario, the radio frequency circuit and the antenna may be disposed remotely and independent of the communication apparatus.

The communication apparatus shown in embodiments of this application may further have more components than those in FIG. 9, or the like. This is not limited in embodiments of this application. The methods performed by the processor and the transceiver are merely examples. For specific steps performed by the processor and the transceiver, refer to the methods described above.

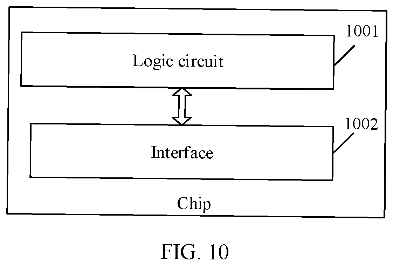

In another possible implementation, in the communication apparatus shown in FIG. 8, the processing module 801 may be one or more logic circuits, and the transceiver module 802 may be an input/output interface that is also referred to as a communication interface, an interface circuit, an interface, or the like. Alternatively, the transceiver module 802 may be a sending module and a receiving module. The sending module may be an output interface, and the receiving module may be an input interface. The sending module and the receiving module are integrated into one module, for example, an input/output interface. As shown in FIG. 10, a communication apparatus shown in FIG. 10 includes a logic circuit 1001 and an interface 1002. In other words, the processing module 801 may be implemented through the logic circuit 1001, and the transceiver module 802 may be implemented through the interface 1002. The logic circuit 1001 may be a chip, a processing circuit, an integrated circuit, a system on chip (system on chip, SoC), or the like. The interface 1002 may be a communication interface, an input/output interface, a pin, or the like. For example, FIG. 10 shows an example in which the communication apparatus is a chip. The chip includes a logic circuit 1001 and an interface 1002.

In this embodiment of this application, the logic circuit and the interface may be coupled to each other. A specific manner of connection between the logical circuit and the interface is not limited in this embodiment of this application. For example, the logic circuit 1001 may be configured to perform the functions or the steps implemented by the processing module 801 shown in FIG. 8, and the interface 1002 may be configured to perform the functions or the steps implemented by the transceiver module 802 shown in FIG. 8. For specific descriptions of the logic circuit 1001 and the interface 1002, refer to FIG. 8 or the foregoing method embodiments. Details are not described herein again.

The communication apparatus shown in embodiments of this application may implement the methods according to embodiments of this application in a form of hardware, or may implement the methods according to embodiments of this application in a form of software. This is not limited in embodiments of this application.

An embodiment of this application further provides a communication system. The communication system includes a first communication apparatus and a second communication apparatus. The first communication apparatus and the second communication apparatus may be configured to perform the method in any one of the foregoing embodiments.

In addition, this application further provides a computer program. The computer program is configured to implement operations and/or processing performed by communication apparatuses in the method provided in this application.

This application further provides a computer-readable storage medium. The computer-readable storage medium stores computer code. When the computer code is run on a computer, the computer is enabled to perform operations and/or processing performed by the communication apparatuses in the methods provided in this application.

This application further provides a computer program product. The computer program product includes computer code or a computer program. When the computer code or the computer program is run on a computer, operations and/or processing performed by the communication apparatuses in the methods provided in this application are/is performed.

In the several embodiments provided in this application, it should be understood that the disclosed system, communication apparatus, and method may be implemented in other manners. For example, the described communication apparatus embodiment is merely an example. For example, the foregoing module division is merely logical function division and there may be another division manner during actual implementation. For example, a plurality of modules or components may be combined or integrated into another system, or some features may be ignored or not performed. In addition, the displayed or discussed mutual couplings or direct couplings or communication connections may be implemented through some interfaces. The indirect couplings or communication connections between the communication apparatuses or modules may be implemented in electronic, mechanical, or other forms.

The modules described as separate parts may or may not be physically separate, and parts displayed as modules may or may not be physical modules, may be located in one position, or may be distributed on a plurality of network modules. Some or all of the modules may be selected based on an actual requirement to achieve the technical effects of the solutions provided in embodiments of this application.

In addition, functional modules in embodiments of this application may be integrated into one processing module, or each of the modules may exist alone physically, or two or more modules may be integrated into one module. The integrated module may be implemented in a form of hardware, or may be implemented in a form of a software functional module.

When the integrated module is implemented in the form of a software functional module and sold or used as an independent product, the integrated unit may be stored in a computer-readable storage medium. Based on such an understanding, the technical solutions of this application essentially, or the part contributing to the conventional technologies, or all or some of the technical solutions may be implemented in a form of a software product. The computer software product is stored in a readable storage medium and includes a plurality of instructions for instructing a computer device (which may be a personal computer, a server, or a network device) to perform all or some of the steps of the methods described in embodiments of this application. The readable storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An encoding method, wherein the method comprises:
obtaining an information bit sequence;
performing low-density parity-check LDPC encoding on the information bit sequence based on a parity check matrix, to obtain an encoded sequence, wherein a length of the encoded sequence is N₁, N₁ is n times 1944, and n is an integer greater than or equal to 2; and
outputting the encoded sequence.

2. A decoding method, wherein the method comprises:
obtaining to-be-decoded information, wherein a length of the to-be-decoded information is N₁, N₁ is n times 1944, and n is an integer greater than or equal to 2; and
performing low-density parity-check LDPC decoding on the to-be-decoded information based on a parity check matrix, to obtain an information bit sequence.

3. The method according to claim 1 or 2, wherein when a coding rate R of the information bit sequence is 1/2, a matrix prototype of the parity check matrix comprises any one of the following matrices: 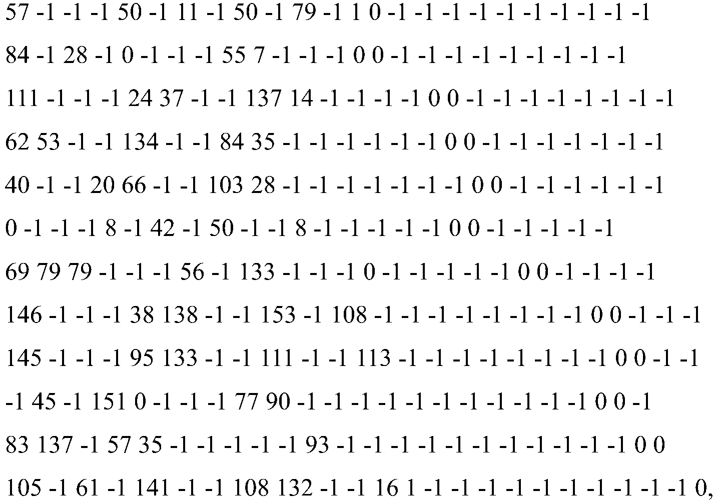 or 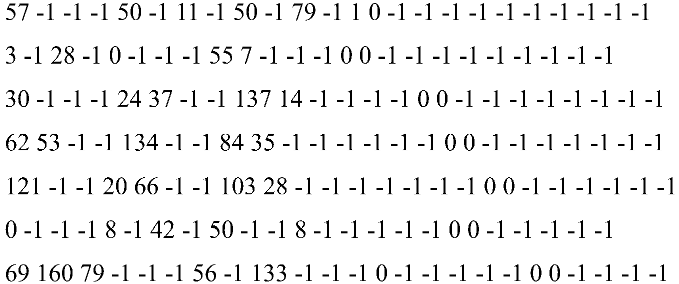 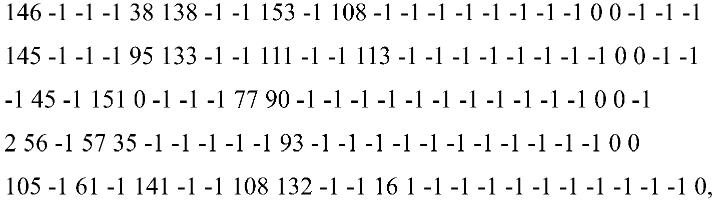 or 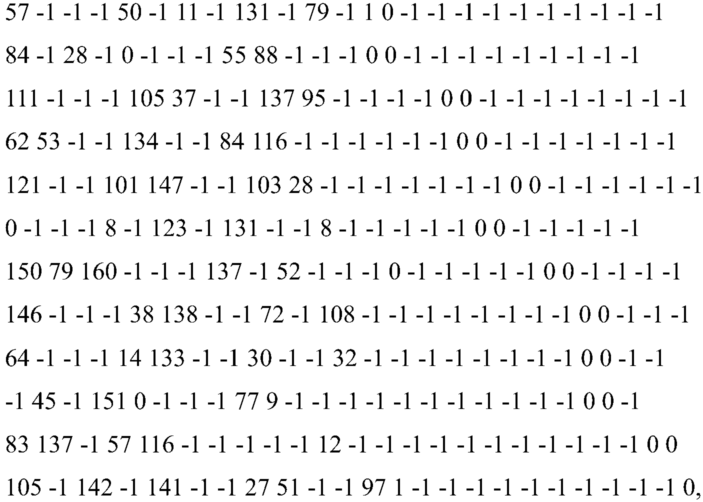 wherein -1 represents an all-zero matrix of Z₁×Z₁, 0 represents an identity matrix of Z₁×Z₁, an element greater than 0 represents a circulant permutation matrix CPM of the identity matrix of Z₁×Z₁, and Z₁ is a positive integer determined based on N₁.

4. The method according to claim 1 or 2, wherein when a coding rate R of the information bit sequence is 2/3, a matrix prototype of the parity check matrix comprises any one of the following matrices: 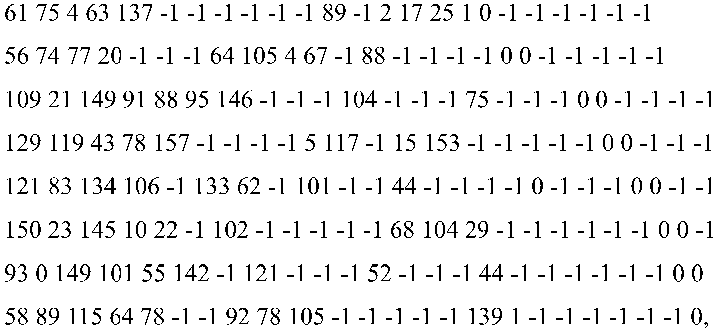 or 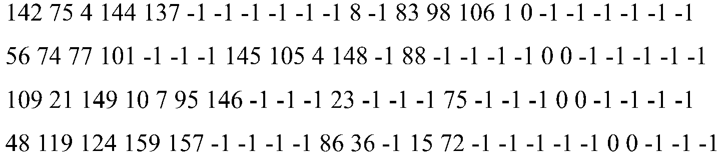 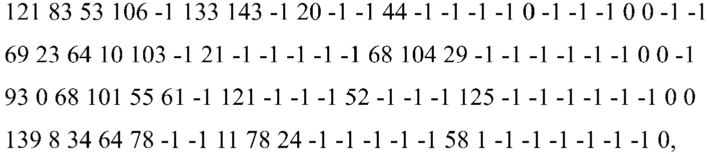 or 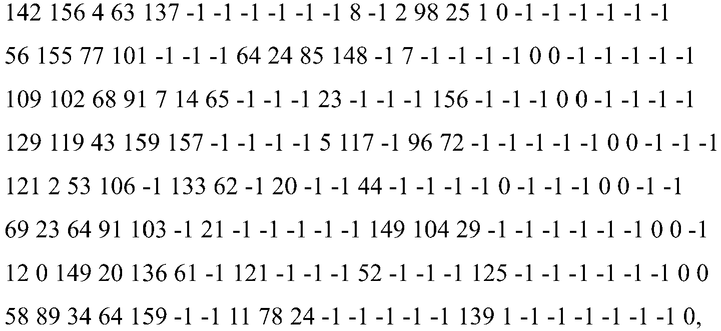 ein -1 represents an all-zero matrix of Z₁×Z₁, 0 represents an identity matrix of Z₁×Z₁, an element greater than 0 represents a circulant permutation matrix CPM of the identity matrix of Z₁×Z₁, and Z₁ is a positive integer determined based on N₁.

5. The method according to claim 1 or 2, wherein when a coding rate R of the information bit sequence is 3/4, a matrix prototype of the parity check matrix comprises any one of the following matrices: 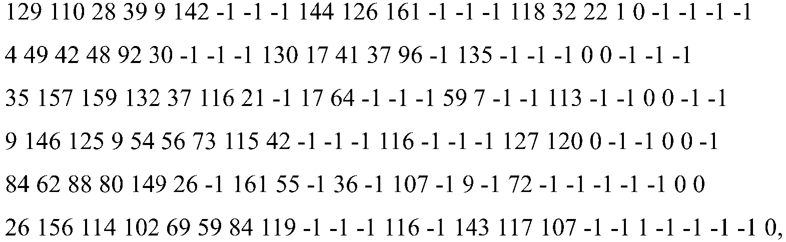 or 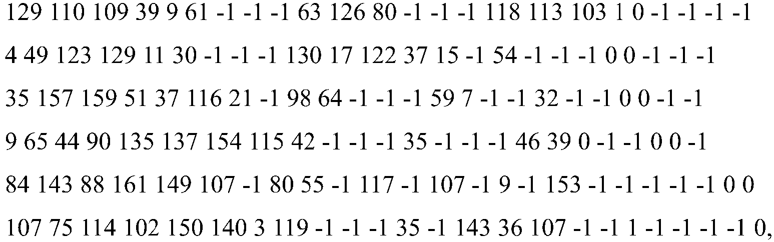 or 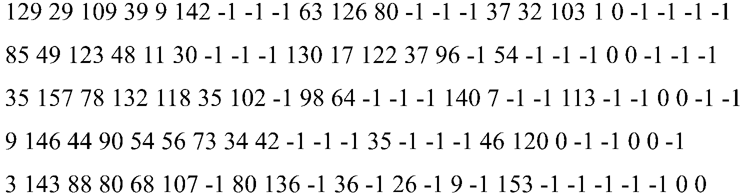 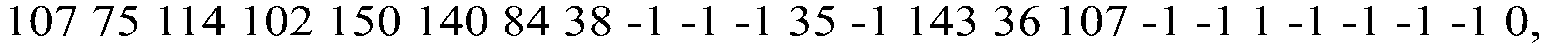 wherein -1 represents an all-zero matrix of Z₁×Z₁, 0 represents an identity matrix of Z₁×Z₁, an element greater than 0 represents a circulant permutation matrix CPM of the identity matrix of Z₁×Z₁, and Z₁ is a positive integer determined based on N₁.

6. The method according to claim 1 or 2, wherein when a coding rate R of the information bit sequence is 5/6, a matrix prototype of the parity check matrix comprises any one of the following matrices: 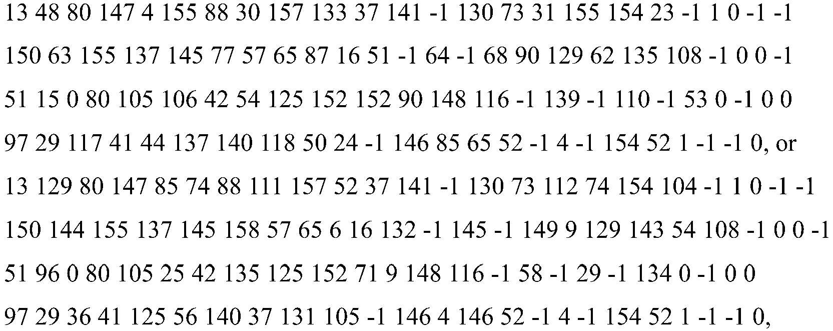 or 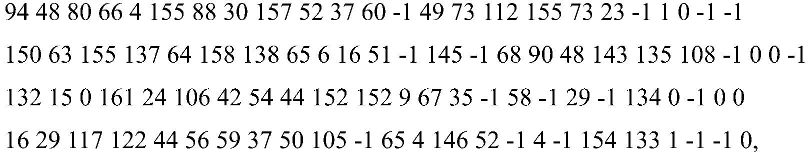 in -1 represents an all-zero matrix of Z₁×Z₁, 0 represents an identity matrix of Z₁×Z₁, an element greater than 0 represents a circulant permutation matrix CPM of the identity matrix of Z₁×Z₁, and Z₁ is a positive integer determined based on N₁.

7. The method according to any one of claims 1 to 6, wherein the parity check matrix is determined based on a reference parity check matrix, a code length N₀ corresponding to the reference parity check matrix is less than or equal to 1944, and a coding rate corresponding to the reference parity check matrix is the same as a coding rate corresponding to the parity check matrix.

8. The method according to any one of claims 1 to 7, wherein that the parity check matrix is determined based on the reference parity check matrix comprises:
Z₁(i, j) and Z₀(i, j) satisfy a modulo operation relationship, wherein
Z₁(i, j) represents an element in an iₜₕ row and a jₜₕ column in a matrix that corresponds to an information bit and that is in the matrix prototype of the parity check matrix, and Z₀(i, j) represents an element in an iₜₕ row and a jₜₕ column in a matrix that corresponds to the information bit and that is in a matrix prototype of the reference parity check matrix.

9. The method according to any one of claims 1 to 8, wherein a matrix that corresponds to a parity bit and that is in the matrix prototype of the parity check matrix is the same as a matrix that corresponds to the parity bit and that is in the matrix prototype of the reference parity check matrix.

10. A communication apparatus, comprising a module configured to perform the method according to any one of claims 1 to 9.

11. A communication apparatus, comprising a processor, wherein the processor is configured to perform the method according to any one of claims 1 to 9.

12. A communication apparatus, comprising a logic circuit and an interface, wherein the logic circuit is coupled to the interface, wherein
the interface is configured to input and/or output information, and the logic circuit is configured to perform the method according to any one of claims 1 to 9.

13. A computer-readable storage medium, wherein the computer-readable storage medium is configured to store a computer program, and when the computer program is executed, the method according to any one of claims 1 to 9 is performed.

14. A computer program product, wherein when the computer program product is executed, the method according to any one of claims 1 to 9 is performed.

15. A communication system, wherein the communication system comprises a first communication apparatus and a second communication apparatus, the first communication apparatus is configured to perform the method according to any one of claim 1 and claims 3 to 9, and the second communication apparatus is configured to perform the method according to any one of claims 2 to 9.
